# EUROPÄISCHE PATENTANMELDUNG

(11) **EP 4 198 167 A1**
(43) Veröffentlichungstag der Anmeldung: **21.06.2023**
(21) Anmeldenummer: 21214441.4
(22) Anmeldetag: 14.12.2021
(51) Int. Cl.: C23C 16/27, C23C 28/00, C23C 28/04

(54) **KÖRPER AUS METALL, EINEM METALLKERAMISCHEN VERBUND ODER KERAMIK MIT EINEM AUF EINER VERSCHLEISSBEANSPRUCHTEN FUNKTIONSFLÄCHE MEHRSCHICHTIG AUSGEBILDETEN VERSCHLEISSSCHUTZSCHICHTSYSTEM, UND VERFAHREN ZUR HERSTELLUNG DIESES KÖRPERS**

(71) Anmelder: Gühring KG, 72458 Albstadt (DE)
(72) Erfinder: GARRN, Immo, 88521 Ertingen (DE); GLUCHE, Peter, 89287 Bellenberg (DE)
(74) Vertreter: Winter, Brandl - Partnerschaft mbB

(57) **Zusammenfassung**

Die vorliegende Erfindung betrifft einen Körper aus Metall, einem metallkeramischen Verbund oder Keramik mit einem auf einer verschleißbeanspruchten Funktionsfläche des Körpers mehrschichtig ausgebildeten Verschleißschutzschichtsystem, und ein Verfahren zur Herstellung dieses Körpers.

## Beschreibung

### Technisches Gebiet

Die vorliegende Erfindung betrifft einen Körper aus Metall, einem metallkeramischen Verbund oder Keramik mit einem auf einer verschleißbeanspruchten Funktionsfläche mehrschichtig ausgebildeten Verschleißschutzschichtsystem gemäß Anspruch 1 und ein Verfahren zur Herstellung dieses Körpers gemäß Anspruch 11.

### Stand der Technik

Industrielle verwendete Apparaturen müssen aufgrund der mannigfaltigen Anwendungsmöglichkeiten vielfältigen Anforderungen genügen. Gerade bei Werkzeugen spielt der an deren tribologisch beanspruchten Funktionsflächen auftretende Verschleiß, beispielsweise bei der Bearbeitung hochabrasiver Werkstoffe, und Strategien zu dessen Verringerung oder Erfassung eine immer größer werdende Rolle im Stand der Technik.

Vor diesem Hintergrund hat sich die Beschichtung von Funktionsflächen, welche bei der Bearbeitung abrasiver Werkstoffe einer hohen Verschleißbeanspruchung standhalten müssen, mit Diamant zur Erhöhung der Verschleißfestigkeit bewährt. Ebenfalls wurden in diesem Zusammenhang Strategien für deren Verschleißerfassung beschrieben.

Hierzu offenbart die Patentschrift EP 0 596 619 A1 einen Gegenstand mit einem Schichtsystem bestehend aus einer ersten, mit Bor dotierten, Diamantschicht und einer darauf befindlichen zweiten undotierten Diamantschicht. Die Dotierung mit Bor verleiht durch dessen Einbau in das Diamant-Kristallgitter der ansonsten nichtleitenden ersten Diamantschicht elektrische Leitfähigkeit, wohingegen die zweite Diamantschicht undotiert vorliegt und rein als Verschleißschutzschicht dient. Folglich unterscheiden sich die erste und zweite Diamantschicht aufgrund der Dotierung auch in ihren physikalisch messbaren Parametern, und hierbei insbesondere hinsichtlich ihren elektrischen Parametern wie beispielsweise der Leitfähigkeit. Zudem wird die Beschichtung einer transparenten Papierführvorrichtung, welche in der Papierherstellung Anwendung findet, mit einem Schichtsystem aus einer ersten Diamantschicht und einer zweiten Diamantschicht, welche sich in ihrer optischen Eigenschaft unterscheiden, und eine Verschleißerfassung basierend auf der Transparenz der Papierführvorrichtung sowie dem Unterschied in der optischen Eigenschaft beider Diamantschichten offenbart.

Die Patentschrift WO 2018 / 166 941 A1 offenbart die Verwendung einer mit Fremdatomen dotierten ersten Diamantschicht aus polykristallinen Diamanten, welche auf einer Metalloberfläche eines spanabhebenden Werkzeugs angeordnet ist, zur Erfassung des Abnutzungsgrades einer undotierten polykristallinen zweiten Diamantschicht, welche auf der dotierten Diamantschicht angeordnet ist, und welche einen Funktionsbereich des spanabhebenden Werkzeugs bildet. Auch hier resultiert die elektrische Leitfähigkeit der ansonsten nichtleitenden ersten Diamantschicht aus der Dotierung mit Bor, wohingegen die zweite Diamantschicht undotiert vorliegt und rein als Verschleißschutzschicht dient. Der auf die Dotierung zurückzuführende Unterschied in der elektrischen Leitfähigkeit ermöglicht bei fortgeschrittener Abnutzung der zweiten undotierten Diamantschicht durch Bearbeitung eines Werkstücks und die hieraus resultierende Kontaktierung der ersten dotierten Diamantschicht mit dem Werkstück die Verschleißerfassung des Werkzeugs basierend auf einer Änderung eines entsprechenden elektrischen Messparameters.

Aus dem Stand der Technik wird somit ersichtlich, dass sich Diamantbeschichtungen zur Erhöhung der Verschleißfestigkeit, und hier insbesondere im Zusammenhang mit Werkzeugen bei der Bearbeitung hochabrasiver Werkstoffe, bewährt haben. Deren Verwendung im Rahmen einer Verschleißerfassung, beispielsweise bei der Bearbeitung eines Werkstücks, ist allerdings gerade im Zusammenhang mit einer Erfassung über elektrische Messparameter immer noch auf die Anwendung von dotierten Diamantschichten beschränkt, da dies derzeit die einzige Möglichkeit darstellt, signifikant elektrisch leitfähige Diamantschichten zu erzeugen. Deren Herstellung wird häufig mittels chemischer Dampfphasenabscheidung (chemical vapour deposition, CVD) durchgeführt und erfordert hierbei die Verwendung eines Dotiergases, wobei abhängig von dem verwendeten Gas n- oder p-leitfähige Diamantschichten erzeugt werden. Dies führt unter Anderem zu erhöhten Kosten und zusätzlicher Komplexität hinsichtlich apparativer und verfahrenstechnischer Aspekte, beispielsweise aufgrund der Notwendigkeit weiterer Schritte wie etwa der Zufuhr eines entsprechenden Dotiergases während des Herstellungsverfahrens der individuellen Schichten. Zudem erfolgt durch die Dotierung eine Veränderung der ursprünglichen chemischen und physikalischen Eigenschaften der Diamantschichten, was beispielsweise in einer Herabsetzung der Verschleißfestigkeit resultieren kann.

### Technische Aufgabe

Ausgehend von der WO 2018 / 166 941 A1 ist es eine Aufgabe der vorliegenden Erfindung, einen verfahrenstechnisch einfacher und kostengünstiger herstellbaren Körper aus Metall, einem metallkeramischen Verbund oder Keramik mit einem auf einer verschleißbeanspruchten Funktionsfläche des Körpers mehrschichtig ausgebildeten Verschleißschutzschichtsystem, sowie ein Verfahren zur Herstellung eines derartigen Körpers bereitzustellen.

### Technische Lösung und vorteilhafte Wirkungen

Diese Aufgabe wird durch den Körper gemäß Anspruch 1, und das Verfahren gemäß Anspruch 11 gelöst.

Im Speziellen betrifft die vorliegende Erfindung einen Körper aus Metall, einem metallkeramischen Verbund oder Keramik mit einem auf einer verschleißbeanspruchten Funktionsfläche des Körpers mehrschichtig ausgebildeten Verschleißschutzschichtsystem, wobei das Verschleißschutzschichtsystem wenigstens eine erste elektrisch leitfähige undotierte Diamantschicht und eine auf der ersten undotierten Diamantschicht angeordnete zweite elektrisch isolierende undotierte Diamantschicht umfasst, wobei die erste elektrisch leitfähige undotierte Diamantschicht n-leitfähig ist.

Wie eingangs erwähnt ist die Modifizierung von Diamantschichten mittels Dotierung zur Erhöhung von deren elektrischer Leitfähigkeit und der hierauf aufbauenden Verwendung zur Verschleißerfassung tribologisch beanspruchter Oberflächen bekannt. Allerdings birgt die Dotierung unter einem verfahrenstechnischen Gesichtspunkt den Nachteil, dass der Einsatz eines entsprechenden Dotiergases notwendig ist, was eine zusätzliche Ausrüstung der Beschichtungsanlage, beispielsweise durch zusätzliche Gasleitungen, Gasbehälter etc. beinhaltet. Zudem werden durch den Einbau von Fremdatomen in das Diamantgitter neben der gewünschten Modifizierung der elektrischen Leitfähigkeit auch andere chemische bzw. physikalische Eigenschaften der Diamantschichten, welche die Verschleißbeständigkeit nachteilig beeinflussen können, verändert. Hieraus ergab sich die Erkenntnis der vorliegenden Lehre, nämlich, dass eine elektrische Leitfähigkeit von Diamantschichten nicht nur wie im Fall von Dotierung durch Einbringen von Fremdatomen in das Diamant-Kristallgitter der Diamantkörner per se hervorgerufen werden kann, sondern eine elektrische Leitfähigkeit im Korngrenzvolumen, also zwischen den Diamantkörnern, erzeugt werden kann, indem die entsprechend elektrisch leitfähige Diamantschicht eine nanokristalline Struktur aufweist. Die Ausbildung als nanokristalline Struktur erlaubt die Koexistenz von sp²- und sp³-hybridisiertem Kohlenstoff, wodurch der Diamantschicht eine n-Leitfähigkeit (n-Typ Leitfähigkeit) verliehen wird. Durch diese Erkenntnis ist es möglich, Körper mit leitfähigen Diamantschichten, und das ohne Dotierung, zu versehen. Folglich erübrigen sich vor einem verfahrenstechnischen Hintergrund der Einsatz von Dotiergas sowie komplexe apparative Ausrüstungen. Ein entsprechend der vorliegenden Lehre aufgebautes Schichtsystem als Verschleißschutz auf einer tribologisch beanspruchten Funktionsfläche eines Körpers ermöglicht es den Verschleißgrad bzw. die Abnutzung des beschichteten Körpers, d.h. eigentlich des Verschleißschutzschichtsystems auf dem Körper, kontinuierlich im laufenden Betrieb zu erfassen. Hierdurch wird ermöglicht, ein Werkzeug, das dem Körper entspricht, frühzeitig anzuhalten, um eine Zerstörung desselben und/oder des gerade bearbeiteten Werkstücks zu vermeiden. Die Erfassung des Verschleißgrades bzw. der Abnutzung des Verschleißschutzschichtsystems kann beispielsweise nach Vorbild der WO 2018 / 166 941 A1 im laufenden Betrieb durch kontinuierliches oder periodisches Erfassen eines elektrischen Messparameters, insbesondere des elektrischen Widerstands und/oder der elektrischen Leitfähigkeit und/oder des kapazitiven Widerstands und/oder der Hall-Spannung oder des Hall-Stroms eines Hall-Sensors, bzw. dessen Änderung im Verlauf der Bearbeitung eines Werkstücks in einer Messkette aus dem Körper mit dem Verschleißschutzschichtsystem, und in der vorliegenden Anmeldung vor allem der elektrisch leitfähigen undotierten Diamantschicht, und dem bearbeiteten Werkstück erfolgen. Alternativ wird durch einen mehrschichtigen Aufbau des Verschleißschutzschichtsystems aus wenigstens zwei elektrisch leitfähigen undotierten Diamantschichten eine kontinuierliche Erfassung des Verschleißgrades bzw. der Abnutzung des beschichteten Körpers bzw. des Verschleißschutzschichtsystems bei der Bearbeitung eines Werkstücks im laufenden Betrieb ermöglicht, indem ein oben genannter elektrischer Messparameter bzw. dessen Änderung beispielsweise im einfachsten Fall in einer Messkette aus zwei undotierten elektrisch leitfähigen Diamantschichten, kontinuierlich oder periodisch erfasst wird. Mit anderen Worten kann hierbei ein oben genannter elektrischer Messparameter bzw. dessen Änderung zwischen den beiden undotierten elektrisch leitfähigen Diamantschichten kontinuierlich oder periodisch erfasst.

Neben den erwähnten verfahrenstechnischen Vorteilen weist der erfindungsgemäße beschichtete Körper die für eine Diamantbeschichtung üblichen Vorteile einer hervorragenden Verschleißfestigkeit auf. Dies ist beispielsweise gerade dann vorteilhaft, wenn es sich bei dem Körper um ein spanabhebendes oder spanlos arbeitendes Werkzeug handelt, da durch eine solche Beschichtung die Standzeit erhöht werden kann.

Die Korngröße der Diamantkörner in der ersten undotierten Diamantschicht kann in einem Bereich von 4 nm bis 10 nm, vorzugsweise in einem Bereich von 5 nm bis 6 nm, und besonders bevorzugt in einem Bereich gegen 5 nm, liegen. Durch die nanokristalline Strukturierung mit betreffender Korngröße kann die elektrische Leitfähigkeit der ersten undotierten Diamantschicht erhöht werden, und somit die Verschleißerfassung *via* elektrische Messparameter verbessert werden.

Die Schichtdicke der ersten undotierten Diamantschicht kann im Bereich von 4 bis 20 µm, vorzugsweise 6 bis 8 µm, liegen, und die Schichtdicke der zweiten undotierten Diamantschicht kann im Bereich von 4 bis 20 µm, vorzugsweise 6 bis 8 µm, liegen. Durch eine größere Schichtschicke der zweiten undotierten Diamantschicht kann eine verbesserte Verschleißschutzschicht ermöglicht werden, da der Körper, beispielsweise als ein spanabhebendes oder spanlos arbeitendes Werkzeug, einer längeren tribologischen, beispielsweise abrasiven, Beanspruchung standhalten kann und auf diese Weise die Standzeit zusätzlich erhöht werden kann.

Die erste und zweite Diamantschicht können mittels chemischer Dampfabscheidung (CVD), vorzugsweise Heißdrahtverfahren, aufgetragen sein. Durch CVD, und insbesondere Heißdrahtverfahren, können die beiden undotierten Schichten einfach und unkompliziert auf den Körper aufgebracht werden.

Der Körper kann Hartstoffpartikel auf Carbid- und/oder Nitrid- und /oder Borid- und/oder Oxid- und/oder Silizid- und/oder Phosphid-Basis enthalten, welche in eine cobalt- und/oder nickelhaltige Bindematrix eingebettet sind. Die Hartstoffpartikel können ausgewählt sein aus der Gruppe, bestehend aus Verbindungen auf Carbid- und/oder Nitrid- und /oder Borid- und/oder Oxid- und/oder Silizid- und/oder Phosphid-Basis der Metalle der IV., V. und VI. Nebengruppe des Periodensystems der Elemente, weiterhin des Bors, des Aluminiums und des Siliziums entweder in reiner Form oder in Mischphasen, insbesondere Titancarbid, Titannitrid, Titancarbonitrid, Wolframcarbid, Vanadiumcarbid, Niobcarbid, Tantalcarbid, Chromcarbid, Molybdäncarbid, (W,Co)₆C, Titandiborid, Zirkondiborid, Hafniumdiborid, Siliziumnitrid, Titanaluminiumnitrid, Aluminiumoxid, Zirkonoxid, Chromoxid oder Spinelle. Carbide der angegebenen Elemente können dem Körper eine hervorragende Härte verleihen. Dies ist besonders vorteilhaft, wenn es sich bei dem Körper um ein spanabhebendes oder spanlos arbeitendes Werkzeug handelt, da sich dies besonders positiv auf die Verschleißfestigkeit sowie Standzeit auswirken kann.

Das mehrschichtig ausgebildete Verschleißschutzschichtsystem kann eine zusätzliche, unter der ersten undotierten Diamantschicht angeordnete, undotierte Diamantschicht aufweisen, welche vorzugsweise in ihrer Zusammensetzung der zweiten undotierten Diamantschicht entspricht. Die zusätzliche undotierte Diamantschicht kann die Haftung der ersten undotierten Diamantschicht auf der Oberfläche des Körpers, insbesondere bei einem Werkzeug aus Hartmetall, zusätzlich verbessern.

Das mehrschichtig ausgebildete Verschleißschutzschichtsystem kann auf der zweiten undotierten Diamantschicht eine dritte undotierte Diamantschicht und eine auf der dritten undotierten Diamantschicht angeordnete vierte undotierte Diamantschicht aufweisen, wobei die dritte Diamantschicht vorzugsweise die gleiche Zusammensetzung wie die erste Diamantschicht aufweist, und die vierte Diamantschicht vorzugsweise die gleiche Zusammensetzung wie die zweite Diamantschicht aufweist. Folglich kann es sich bei der dritten und/oder der vierten undotierten Diamantschicht um eine Schicht aus polykristallinen Diamanten, welche in der vorliegenden Anmeldung auch als polykristalline Diamantschicht bezeichnet wird, handeln. Durch das Einbringen weiterer Schichten wie der dritten und vierten Diamantschicht kann die Festigkeit und Härte des Verschleißschutzschichtsystems und folglich Verschleißbeständigkeit des Körpers zusätzlich erhöht werden. Hierdurch kann, sofern es sich bei dem Körper um ein spanabhebendes oder spanlos arbeitendes Werkzeug handelt, die Standzeit erhöht werden. Zudem kann dies eine kontinuierliche Erfassung des Abnutzungsgrades des Verschleißschutzschichtsystems bzw. Körpers (bzw. des spanabhebenden oder spanlos arbeitenden Werkzeugs) ermöglichen.

Der Körper kann insbesondere ein spanabhebendes oder spanlos arbeitendes Werkzeug sein. Hierbei kann es sich gegebenenfalls um ein als rotierendes oder stehendes Werkzeug, insbesondere ein als Bohr-, Fräs-, Senk-, Dreh-, Gewinde-, Konturier- oder Reibwerkzeug ausgebildetes Werkzeug, handeln. Ein spanabhebendes oder spanlos arbeitendes Werkzeug aus Metall, einem metallkeramischen Verbund oder Keramik mit einem auf einer verschleißbeanspruchten Funktionsfläche des Werkzeugs mehrschichtig ausgebildeten Verschleißschutzschichtsystem kann eine hervorragende Verschleißfestigkeit bei der Bearbeitung von hochabrasiven Werkstoffen aufweisen.

Weiterhin betrifft die vorliegende Erfindung ein Verfahren zur Herstellung eines Körpers gemäß einer der oben beschriebenen Ausgestaltungen, wobei das Verfahren das Aufbringen eines mehrschichtig ausgebildeten Verschleißschutzschichtsystems auf eine verschleißbeanspruchte Funktionsfläche des Körpers mittels chemischer Dampfabscheidung (CVD) aus einer Methan/Wasserstoff-Atmosphäre in einer CVD-Kammer umfasst. Vorzugsweise wird Wasserstoff dem Methan im molaren Überschuss zugemischt, und eine Beschichtungstemperatur von 650°C bis 1100°C, vorzugsweise 650°C bis 750°C, und ein Beschichtungsdruck von 1 mbar bis 10 mbar bzw. 1 hPa bis 10 hPa eingestellt. Weiterhin kann als CVD-Verfahren ein Heißdrahtverfahren zum Einsatz kommen, bei welchem vorzugsweise ein W-Draht als Heizdraht verwendet wird. Durch Ausbleiben des Dotiergases ist das Verfahren gegenüber konventionell durchgeführten CVD-Verfahren, welche zur Abscheidung elektrisch leitfähiger Diamantschichten angewendet werden, aus verfahrenstechnischer bzw. apparativer Sicht einfacher und kostengünstiger. Zudem kann durch dieses Verfahren die Herstellung eines erfindungsgemäßen Körpers gewährleistet werden, dessen Verschleißerfassung anhand eines elektrischen Messparameters ohne die Notwendigkeit einer Dotierung ermöglicht wird.

### Kurzbeschreibung der Figuren

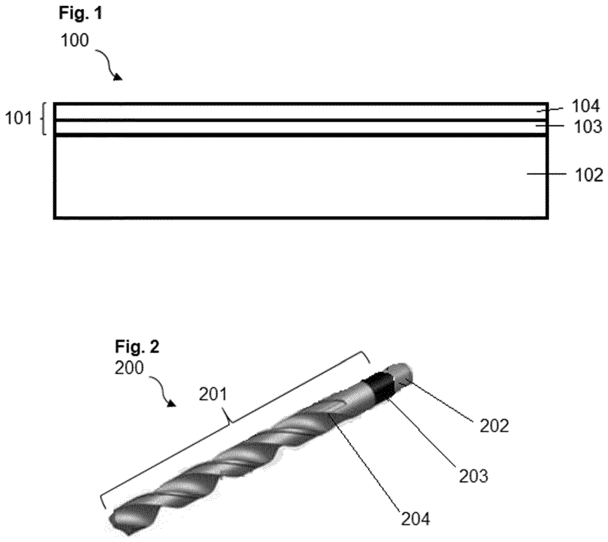

Fig. 1 zeigt schematisch einen beschichteten Körper mit einem mehrschichtig ausgebildeten Verschleißschutzschichtsystem gemäß einer ersten Ausführungsform in einer Seiten- oder Querschnittsansicht. In Fig. 2 ist schematisch der beschichtete Körper gemäß der ersten Ausführungsform als ein spanabhebendes Werkzeug mit einem mehrschichtig ausgebildeten Verschleißschutzschichtsystem in einer Seitenansicht dargestellt.

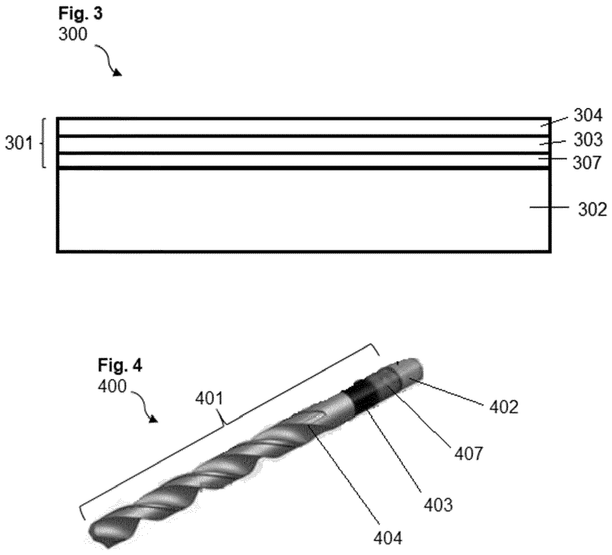

Fig. 3 zeigt schematisch einen beschichteten Körper mit einem mehrschichtig ausgebildeten Verschleißschutzschichtsystem gemäß einer zweiten Ausführungsform in einer Seiten- oder Querschnittsansicht. In Fig. 4 ist schematisch der beschichtete Körper gemäß der zweiten Ausführungsform als ein spanabhebendes Werkzeug mit einem mehrschichtig ausgebildeten Verschleißschutzschichtsystem in einer Seitenansicht dargestellt.

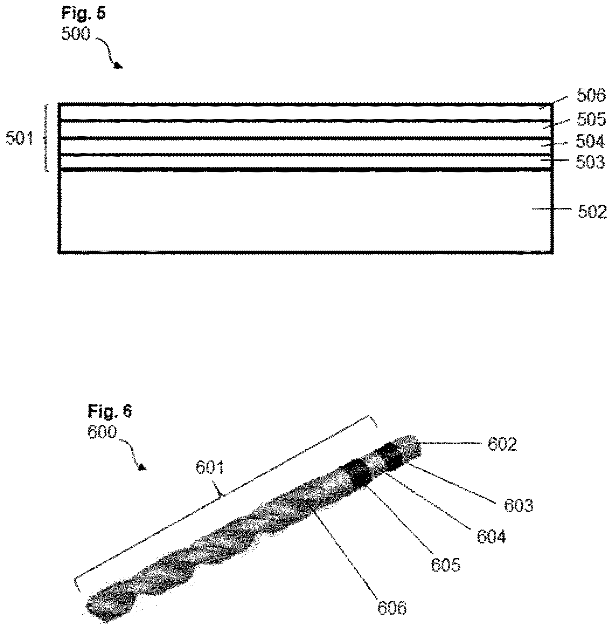

Fig. 5 zeigt schematisch einen beschichteten Körper mit einem mehrschichtig ausgebildeten Verschleißschutzschichtsystem gemäß einer dritten Ausführungsform in einer Seiten- oder Querschnittsansicht. In Fig. 6 ist schematisch der beschichtete Körper gemäß der dritten Ausführungsform als ein spanabhebendes Werkzeug mit einem mehrschichtig ausgebildeten Verschleißschutzschichtsystem in einer Seitenansicht dargestellt.

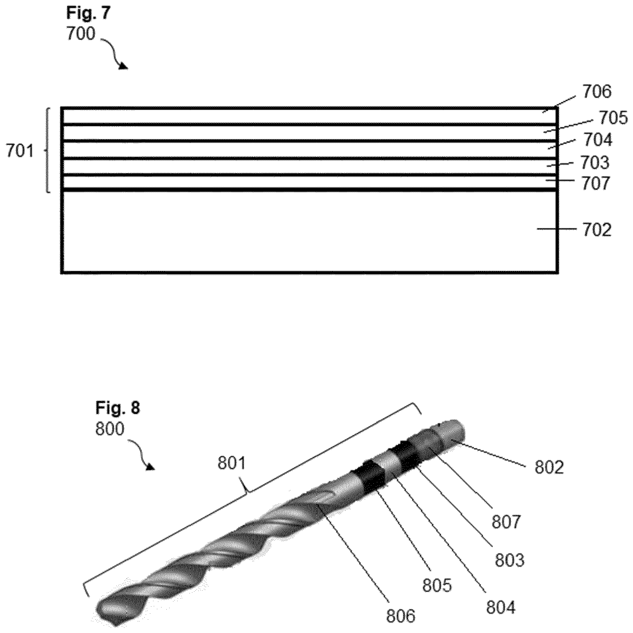

Fig. 7 zeigt schematisch einen beschichteten Körper mit einem mehrschichtig ausgebildeten Verschleißschutzschichtsystem gemäß einer vierten Ausführungsform in einer Seiten- oder Querschnittsansicht. In Fig. 8 ist schematisch der beschichtete Körper gemäß der vierten Ausführungsform als ein spanabhebendes Werkzeug mit einem mehrschichtig ausgebildeten Verschleißschutzschichtsystem in einer Seitenansicht dargestellt.

### Detaillierte Beschreibung der Ausführungsformen

Fig. 1 zeigt schematisch einen beschichteten Körper 100 mit einem mehrschichtig ausgebildeten Verschleißschutzschichtsystem 101 gemäß einer ersten Ausführungsform in einer Seiten- oder Querschnittsansicht. Erfindungsgemäß weist der Körper 102 ein mehrschichtiges, darauf ausgebildetes Verschleißschutzschichtsystem 101 auf. Mit anderen Worten trägt der Körper 102 das mehrschichtig ausgebildete Verschleißschutzschichtsystem 101. Das mehrschichtig ausgebildete Verschleißschutzschichtsystem 101 kann direkt auf der Oberfläche des Körpers 102 angeordnet sein.

Erfindungsgemäß umfasst das mehrschichtig ausgebildete Verschleißschutzschichtsystem 101 wenigstens eine erste undotierte Diamantschicht 103 und eine zweite undotierte Diamantschicht 104. Die zweite undotierte Diamantschicht 104 ist auf der ersten undotierten Diamantschicht 103 angeordnet. In dem Verschleißschutzschichtsystem 101 gemäß der ersten Ausführungsform befindet sich folglich aufgrund einer solchen Schichtanordnung, von der Stapelrichtung aus gesehen, die zweite undotierte Diamantschicht 104 an der vom Körper 102 entferntesten Position im Verschleißschutzschichtsystem 101. Mit anderen Worten ist die zweite undotierte Diamantschicht 104 in dem Verschleißschutzschichtsystem 101 gemäß der ersten Ausführungsform aufgrund einer solchen Schichtanordnung bei der Anwendung des Körpers, beispielsweise - wenn es sich bei dem Körper um ein spanabhebendes Werkzeug handelt - bei einer spanabhebenden Bearbeitung eines Werkstücks, in direktem Kontakt mit dem Werkstück. Eine derartige Anordnung ermöglicht zudem die Verwendung der ersten undotierten Diamantschicht 103 zur Erfassung des Verschleißes bzw. Abnutzungsgrades der zweiten undotierten Diamantschicht 104 aufgrund der im folgenden elaborierten Eigenschaften der ersten und zweiten undotierten Diamantschicht.

Erfindungsgemäß sind weder die erste noch die zweite Diamantschicht 103, 104 dotiert. Der Begriff "Dotierung" und Verfahren hierfür sind dem Fachmann bekannt. Allgemeinhin bedeutet Dotieren das gezielte Einbringen von Verunreinigungen in Form von Fremdatomen in eine Schicht bzw. ein Grundmaterial, wie beispielsweise in der vorliegenden Anmeldung in ein Diamant-Kristallgitter. Dieser Vorgang kann beispielweise bereits bei der Beschichtung durch Beimischen eines Dotiergases in das Beschichtungsgas, oder nachträglich mittels Ionenimplantation einer bereits erzeugten Schicht erfolgen. Durch die Wahl der entsprechend eingebrachten Fremdatome liegt eine n- oder p-Typ-Dotierung vor. Wie eingangs erwähnt werden derartige Dotierungsverfahren im Stand der Technik bereits zur Modifizierung von Diamantschichten genutzt, um deren chemische bzw. physikalische Eigenschaften zu verändern. Diamant weist bekanntermaßen als Modifikation des Kohlenstoffs aufgrund der sp³-Hybridisierung der 2s / 2p Kohlenstoff-Atomorbitale ein kubisches Kristallsystem auf. Praktisch wirken Diamantschichten undotiert als Isolator und weisen keine signifikante elektrische Leitfähigkeit auf. Durch eine Dotierung, wie beispielsweise in WO 2018 / 166 941 A1 beschrieben, kann die elektrische Leitfähigkeit der Diamantschicht durch gezielten Einbau von Boratomen in das Kristallsystem erhöht werden. Die erste und zweite Diamantschicht 103, 104 im mehrschichtig ausgebildeten Verschleißschutzschichtsystem 101 gemäß der ersten Ausführungsform liegen jedoch undotiert vor. Hierdurch ist es nicht notwendig ein Dotiergas während der Erzeugung bzw. Auftragung der einzelnen Diamantschichten 103, 104, beispielsweise mittels Heißdrahtverfahren, zu verwenden, was in einem einfacher und kostengünstiger hergestellten beschichteten Körper 100 resultiert. Zudem kann durch das Ausbleiben einer Schwächung des Kristallgitters der Diamantschicht 103, 104 aufgrund des Einbaus von Fremdatomen durch Dotierung eine in der Härte und Festigkeit, und folglich Verschleißbeständigkeit, verbesserte Diamantschicht 103, 104 resultieren.

Erfindungsgemäß unterscheiden sich die erste undotierte Diamantschicht 103 und die zweite undotierte Diamantschicht 104 hinsichtlich ihrer elektrischen Leitfähigkeit. So handelt es sich bei der ersten undotierten Diamantschicht 103 um eine elektrisch leitfähige Diamantschicht, wohingegen die zweite undotierte Diamantschicht 104 eine elektrisch isolierende Diamantschicht ist. Die elektrische Leitfähigkeit der zweiten undotierten Diamantschicht 104 kann in einem Bereich zwischen 9,8×10⁻⁶ S/cm und 9,2×10⁻⁹ S/cm liegen. Die elektrische Leitfähigkeit der ersten undotierten Diamantschicht 103 kann in einem Bereich zwischen 10 S/cm und 12 S/cm liegen.

Wie oben erwähnt wird die Dotierung im Stand der Technik zur Modifizierung chemischer bzw. physikalischer Eigenschaften, gerade auch der elektrischen Leitfähigkeit, von Diamantschichten genutzt. In der vorliegenden Erfindung sind allerdings weder die erste noch die zweite Diamantschicht 103, 104 dotiert. Der Unterschied der ersten undotierten Diamantschicht 103 zur zweiten undotierten Diamantschicht 104 hinsichtlich ihrer elektrischen Leitfähigkeit wird durch die Struktur bzw. Zusammensetzung der ersten undotierten Diamantschicht 103 im Vergleich zur zweiten undotierten Diamantschicht 104 ermöglicht. Die erste undotierte Diamantschicht 103 weist eine nanokristalline Struktur auf. Dies bedeutet, dass in der ersten undotierten Diamantschicht 103 Diamantkörner mit einer Korngröße im Nanometerbereich enthalten sind. Diese Diamantkörner mit einer Korngröße im Nanometerbereich können eine Korngröße in einem Bereich von 4 nm bis 10 nm, vorzugsweise in einem Bereich von 5 nm bis 6 nm, und besonders bevorzugt in einem Bereich gegen 5 nm, aufweisen. Mit anderen Worten weist die erste undotierte Diamantschicht 103 eine nanokristalline Struktur auf, vorzugsweise wobei die Korngröße der Diamantkörner in einem Bereich von 4 nm bis 10 nm, mehr bevorzugt in einem Bereich von 5 nm bis 6 nm, und besonders bevorzugt in einem Bereich gegen 5 nm, liegt. Diese Diamantkörner mit einer Korngröße im Nanometerbereich weisen eine für Diamant übliche Kristallstruktur auf. Diese entspricht wie oben erwähnt aufgrund der sp³-Hybridisierung der 2s / 2p Kohlenstoff-Atomorbitale einem kubischen Kristallsystem.

Zudem enthält die erste undotierte Diamantschicht 103 neben diesen Diamantkörnern mit einer Korngröße im Nanometerbereich und sp³-hybridisierter Kohlenstoff-Atomorbitalstruktur auch Graphen oder Graphit, und zwar an den Korngrenzen der Diamantkörner, welche eine Korngröße im Nanometerbereich und Bindungen basierend auf einer sp³-hybridisierten Kohlenstoff-Atomorbitalstruktur aufweisen. Mit anderen Worten ist das in der ersten undotierten Diamantschicht 103 enthaltene Graphen oder Graphit zwischen den Diamantkörnern mit einer Korngröße im Nanometerbereich und Bindungen basierend auf einer sp³-hybridisierter Kohlenstoff-Atomorbitalstruktur angeordnet.

Graphen oder Graphit weist bekanntermaßen als Modifikation des Kohlenstoffs aufgrund der sp²-Hybridisierung der 2s / 2p Kohlenstoff-Atomorbitale eine hexagonale oder trigonale Kristallstruktur auf. Charakteristisch ist das Vorliegen als flächiges System aus kovalent gebundenen hexagonalen Kohlenstoff-Ringen und zur σ-Bindungsebene senkrecht stehende π-Bindungen. Die elektrische Leitfähigkeit entlang des flächigen Systems wird hierbei durch die delokalisierten π-Elektronen ermöglicht. Die erste undotierte Diamantschicht 103 kann in diesem Zusammenhang als n-leitfähig bzw. n-Typ leitfähig bezeichnet werden. Dies bedeutet, dass die elektrische Leitfähigkeit - ähnlich derer, welche sich bei der Dotierung durch den Einbau von beispielsweise Phosphoratomen in das Diamant-Kristallgitter ergibt - durch einen Elektronendonator, im Fall der vorliegenden Erfindung durch die delokalisierten π-Elektronen des Graphits oder Graphens, hervorgerufen wird. Jedoch besteht gegenüber der im Stand der Technik durch Dotierung des Diamant-Kristallgitters per se hervorgerufenen elektrischen Leitfähigkeit der fundamentale Unterschied in der vorliegenden Erfindung darin, dass die elektrische Leitung an den Korngrenzen auftritt und somit von einer (elektrischen) Korngrenzleitfähigkeit gesprochen werden kann. Indem in der ersten undotierten Diamantschicht 103 Graphen oder Graphit mit einer sp²-Hybridisierung der 2s / 2p Kohlenstoff-Atomorbitale zwischen den Diamantkörnern mit einer Korngröße im Nanometerbereich und Bindungen basierend auf einer sp³-hybridisierter Kohlenstoff-Atomorbitalstruktur angeordnet ist, wird somit die elektrische Leitfähigkeit der ersten undotierten Diamantschicht 103 signifikant erhöht.

Der Unterschied zwischen der ersten undotierten Diamantschicht 103 und der zweiten undotierten Diamantschicht 104 hinsichtlich ihrer elektrischen Leitfähigkeit kann auch in einem Unterschied hinsichtlich eines definierten elektrischen Messparameters der beiden Schichten resultieren. Bei dem elektrischen Messparameter kann es sich um den elektrischen Widerstand und/oder die elektrische Leitfähigkeit und/oder den kapazitiven Widerstand und/oder die Hall-Spannung oder den Hall-Strom eines Hall-Sensors handeln.

Bei der ersten und/oder der zweiten undotierten Diamantschicht 103, 104 kann es sich um eine Schicht aus polykristallinen Diamanten, welche in der vorliegenden Anmeldung auch als polykristalline Diamantschicht bezeichnet wird, handeln. Die Schichtdicke der ersten undotierten Diamantschicht 103 kann im Bereich von 4 bis 20 µm, vorzugsweise 6 bis 8 µm, liegen, und die Schichtdicke der zweiten undotierten Diamantschicht 104 kann im Bereich von 4 bis 20 µm, vorzugsweise 6 bis 8 µm, liegen. Durch eine größere Schichtschicke der zweiten undotierten Diamantschicht 104 kann eine Verbesserung der Verschleißschutzschicht erreicht werden, so dass der beschichtete Körper 100, beispielsweise bei der Verwendung bei der Bearbeitung eines Werkstücks, einer länger andauernden tribologischen, beispielsweise abrasiven, Beanspruchung standhalten kann.

Bei der ersten und der zweiten undotierten Diamantschicht 103, 104 kann es sich um Diamantschichten handeln, welche mittels chemischer Dampfabscheidung (chemical vapour deposition, CVD) erzeugt bzw. aufgebracht sind. Verfahren zur chemischen Dampfphasenabscheidung sind dem Fachmann bereits aus dem Stand der Technik bekannt. Die gängigsten Verfahren umfassen das Heißdrahtverfahren (hot filament CVD oder HF-CVD), das Mikrowellenplasmaverfahren (microwave plasma CVD, MWP-CVD) und das Plasma-Jet-Verfahren. Folglich kann die erste und zweite undotierte Diamantschicht 103, 104 eine mittels Heißdrahtverfahren erzeugte bzw. aufgebrachte Diamantschicht, eine mittels Mikrowellenplasmaverfahren erzeugte bzw. aufgebrachte Diamantschicht oder eine mittels Plasma-Jet-Verfahren erzeugte bzw. aufgebrachte Diamantschicht sein. Vorzugsweise handelt es sich bei der ersten und zweiten undotierten Diamantschicht 103, 104 um eine mittels Heißdrahtverfahren erzeugte bzw. aufgebrachte Diamantschicht. Die oben beschriebene Struktur bzw. Zusammensetzung der ersten undotierten Diamantschicht 103, nämlich einer Anordnung von Graphen oder Graphit zwischen nanokristallinen Diamantkörnern, und der zweiten undotierten Diamantschicht 104 kann durch Einstellung der CVD-Bedingungen, insbesondere bei einem Heißdrahtverfahren, erreicht werden. Bei mittels Heißdrahtverfahren erzeugten bzw. aufgebrachten Diamantschichten ergibt sich der Vorteil, dass, beispielsweise im Vergleich zum Plasmaverfahren, eine größere Flexibilität bei geringeren Beschichtungstemperaturen erreicht wird. Die für das Heißdrahtverfahren verwendeten Drähte - hierbei kann es sich um W-Drähte handeln - können an die unterschiedlichen Geometrien des zu beschichtenden Körpers 102 angepasst werden, da für den Schichtaufbau ein bestimmter Abstand zu den heißen Drähten eingehalten werden muss, welcher typischerweise im Bereich von ca. 5 mm bis 30 mm liegt. Dies kann besonders dann vorteilhaft sein, wenn es sich bei dem Körper um ein spanabhebendes oder spanlos arbeitendes Werkzeug handelt, da diese eine komplexe geometrische Struktur aufweisen können. Je nach Art und Aufbau des Werkzeugs ist es somit gegebenenfalls möglich, auch Hinterschneidungen und Rückseiten zu beschichten.

Der Körper 102 besteht aus einem Metall, einem metallkeramischen Verbund oder einer Keramik. Der metallkeramische Verbund bzw. die metallkeramischen Verbundwerkstoffe können Hartstoffpartikel auf Carbid- und/oder Nitrid- und /oder Borid- und/oder Oxid- und/oder Silizid- und/oder Phosphid-Basis, welche in eine cobalt- und/oder nickelhaltige Bindematrix eingebettet sind, enthalten. Diese Hartstoffpartikel können in unterschiedlichen Volumenverhältnissen in dem metallkeramischen Verbundwerkstoff enthalten sein. Die Hartstoffpartikel können ausgewählt sein aus den soeben genannten Verbindungen der Metalle der IV., V. und VI. Nebengruppe des Periodensystems der Elemente, weiterhin des Bors, des Aluminiums und des Siliziums entweder in reiner Form oder in Mischphasen. In M₆C und M₁₂C-Phasen, wobei M für das entsprechende Metall steht, können auch Metalle der VII. und VIII. Nebengruppe enthalten sein. Bei Verwendung metallischer Werkstoffe für den Körper 102 können in diesem Metall ebenfalls diese Hartstoffe zulegiert sein. Keramische Werkstoffe können aus den genannten Phasen in Reinform oder in Mischung bestehen, silikatisch sein oder MgO beinhalten. Beispiele für die Hartstoffe können insbesondere Titancarbid, Titannitrid, Titancarbonitrid, Wolframcarbid, Vanadiumcarbid, Niobcarbid, Tantalcarbid, Chromcarbid, Molybdäncarbid, (W,Co)₆C, Titandiborid, Zirkondiborid, Hafniumdiborid, Siliziumnitrid, Titanaluminiumnitrid, Aluminiumoxid, Zirkonoxid, Chromoxid oder Spinelle sein.

Erfindungsgemäß ist das mehrschichtig ausgebildete Verschleißschutzschichtsystem 101 auf einer verschleißbeanspruchten Funktionsfläche des Körpers 102 angeordnet. Die verschleißbeanspruchte Funktionsfläche kann sich je nach Art und Aufbau des Körpers 102 oder dessen Anforderungsprofil unterscheiden.

Beispielsweise kann der beschichtete Körper 100 ein spanabhebendes oder spanlos arbeitendes Werkzeug sein.

In Fig. 2 ist schematisch der beschichtete Körper 100 gemäß der ersten Ausführungsform als ein spanabhebendes Werkzeug 200 mit einem mehrschichtig ausgebildeten Verschleißschutzschichtsystem 201 in einer Seitenansicht dargestellt. Wenn es sich bei dem beschichteten Körper 100 um ein spanabhebendes oder spanlos arbeitendes Werkzeug handelt, so handelt es sich bei dem Körper 102 um einen Werkzeugkörper 202. Das in Fig. 2 schematisch dargestellte spanabhebende Werkzeug 200 weist auf dem Werkzeugkörper 202 auf einer verschleißbeanspruchten Funktionsfläche des Werkzeugs ein mehrschichtiges, darauf ausgebildetes Verschleißschutzschichtsystem 201 auf, welches eine erste elektrisch leitfähige undotierte Diamantschicht 203 und eine zweite elektrisch isolierende undotierte Diamantschicht 204 aufweist. Die erste elektrisch leitfähige undotierte Diamantschicht 203 kann auf dem Werkzeugkörper 202 angeordnet sein. Die zweite elektrisch isolierende undotierte Diamantschicht 204 kann auf der ersten elektrisch leitfähigen undotierten Diamantschicht 203 angeordnet sein. Die chemischen und physikalischen Eigenschaften, wie etwa Struktur bzw. Zusammensetzungen, der ersten und zweiten undotierten Diamantschicht 203, 204 aus Fig. 2 entsprechen jeweils denen der oben im Zusammenhang mit dem beschichteten Körper 100 in Fig. 1 beschriebenen ersten und zweiten undotierten Diamantschicht 103, 104. Hierbei entspricht die erste undotierte Diamantschicht 203 in Fig. 2 der ersten undotierten Diamantschicht 103 in Fig. 1, die zweite undotierte Diamantschicht 204 in Fig. 2 der zweiten undotierten Diamantschicht 104 in Fig. 1, und das mehrschichtig ausgebildete Verschleißschutzschichtsystem 201 in Fig. 2 dem mehrschichtig ausgebildeten Verschleißschutzschichtsystem 101 in Fig. 1.

Im Fall eines spanabhebenden Werkzeugs kann es sich bei der verschleißbeanspruchten Funktionsfläche insbesondere um die an der Zerspanung beteiligten Fläche an einem Schneidteil des Werkzeugs handeln. Beispielsweise kann das Werkzeug als ein rotierendes oder stehendes Werkzeug, insbesondere als ein Bohr-, Fräs-, Senk-, Dreh-, Gewinde-, Konturier- oder Reibwerkzeug, ausgebildet sein. Das Werkzeug, vorzugsweise zur spanabhebenden Bearbeitung, kann einen Werkzeugkopf, einen Werkzeugschaft und einen Einspannabschnitt zur Aufnahme in einer Werkzeugaufnahme umfassen. Dementsprechend kann es sich bei der verschleißbeanspruchten Funktionsfläche des, vorzugsweise spanabhebenden, Werkzeuges um eine Fläche des bei der Bearbeitung mit einem Werkstück in Kontakt tretenden Schneidteils (Werkzeugkopf) oder eine Fläche des Einspannabschnitts zur Aufnahme in einer Werkzeugaufnahme handeln. Indem es sich bei der verschleißbeanspruchten Funktionsfläche um eine Fläche des bei der Bearbeitung mit einem Werkstück in Kontakt tretenden Werkzeugkopfes handelt, kann durch das erfindungsgemäße Verschleißschutzschichtsystem die Beständigkeit des Werkzeugs gegen Verschleiß erhöht werden. Indem es sich bei der verschleißbeanspruchten Funktionsfläche um eine Fläche des Einspannabschnitts zur Aufnahme in einer Werkzeugaufnahme handelt, kann durch das erfindungsgemäße Verschleißschutzschichtsystem die Beständigkeit des Werkzeugs gegen Verschleiß erhöht werden, weil der Verschleiß der entsprechenden Fläche bei wiederholten Ein- und Ausspannvorgängen verringert wird. Zudem ermöglicht ein entsprechend der vorliegenden Lehre aufgebautes Verschleißschutzschichtsystem auf einer tribologisch beanspruchten Funktionsfläche eines Körpers bzw. Werkzeugs die Erfassung des Verschleißgrades bzw. der Abnutzung des beschichteten Körpers, d.h. eigentlich des Verschleißschutzschichtsystems auf dem Körper, im laufenden Betrieb. Hierbei erfolgt die Erfassung des Verschleißgrades bzw. der Abnutzung des Verschleißschutzschichtsystems beispielsweise nach Vorbild der WO 2018 / 166 941 A1. Diese beschreibt die kontinuierliche oder periodische Erfassung eines elektrischen Messparameters, insbesondere des elektrischen Widerstands und/oder der elektrischen Leitfähigkeit, bzw. vor allem dessen Änderung im Verlauf der Bearbeitung eines Werkstücks in einem Gesamtsystem umfassend ein metallisches Werkstück sowie ein Werkzeug mit der Schichtenfolge einer metallischen Substratschicht, einer dotierten Diamantschicht und einer undotierten Diamantschicht. Somit kann in der vorliegenden Anmeldung ebenfalls die Erfassung des Verschleißgrades bzw. der Abnutzung des Verschleißschutzschichtsystems durch die kontinuierliche oder periodische Erfassung eines elektrischen Messparameters, insbesondere des elektrischen Widerstands und/oder der elektrischen Leitfähigkeit und/oder des kapazitiven Widerstands und/oder der Hall-Spannung oder des Hall-Strom eines Hall-Sensors, bzw. vor allem dessen Änderung im Verlauf der Bearbeitung eines Werkstücks in einer Messkette aus dem Körper bzw. Werkzeug mit dem Verschleißschutzschichtsystem, und in der vorliegenden Anmeldung vor allem der elektrisch leitfähigen undotierten Diamantschicht, und dem bearbeiteten Werkstück erfolgen.

Fig. 3 zeigt einen beschichteten Körper 300 mit einem mehrschichtig ausgebildeten Verschleißschutzschichtsystem 301 gemäß einer zweiten Ausführungsform in einer Seiten- oder Querschnittsansicht. Der in Fig. 3 schematisch dargestellte beschichtete Körper 300 weist auf dem Körper 302 auf einer verschleißbeanspruchten Funktionsfläche des Körpers ein mehrschichtiges, darauf ausgebildetes Verschleißschutzschichtsystem 301 auf, welches eine zusätzliche undotierte Diamantschicht 307, eine erste elektrisch leitfähige undotierte Diamantschicht 303 und eine zweite elektrisch isolierende undotierte Diamantschicht 304 aufweist. Die erste elektrisch leitfähige undotierte Diamantschicht 303 kann auf der zusätzlichen undotierten Diamantschicht 307 angeordnet sein. Die zweite elektrisch isolierende undotierte Diamantschicht 304 kann auf der ersten elektrisch leitfähigen undotierten Diamantschicht 303 angeordnet sein. Die chemischen und physikalischen Eigenschaften, wie etwa Struktur bzw. Zusammensetzungen, der ersten und zweiten undotierten Diamantschicht 303, 304 aus Fig. 3 entsprechen jeweils denen der oben im Zusammenhang mit dem beschichteten Körper 100 gemäß der ersten Ausführungsform in Fig. 1 beschriebenen ersten und zweiten undotierten Diamantschicht 103, 104. Hierbei entspricht die erste undotierte Diamantschicht 303 in Fig. 3 der ersten undotierten Diamantschicht 103 in Fig. 1, die zweite undotierte Diamantschicht 304 in Fig. 3 der zweiten undotierten Diamantschicht 104 in Fig. 1.

Der in Fig. 3 dargestellte beschichtete Körper 300 gemäß der zweiten Ausführungsform unterscheidet sich von dem in Fig. 1 dargestellten beschichteten Körper 100 gemäß der ersten Ausführungsform lediglich dahingehend, dass das mehrschichtig ausgebildete Verschleißschutzschichtsystem 301 unter der ersten undotierten Diamantschicht 303 eine zusätzliche undotierte Diamantschicht 307 aufweist. Mit "unter der ersten undotierten Diamantschicht" ist eine Anordnung zwischen dem Körper 302 und der ersten elektrisch leitfähigen undotierten Diamantschicht 303 gemeint. In diesem Fall ist also die zusätzliche undotierte Diamantschicht 307 auf dem Körper 302 angeordnet, und auf dieser ist die erste elektrisch leitfähige undotierte Diamantschicht 303 angeordnet. Diese zusätzliche undotierte Diamantschicht 307 kann in ihrer Struktur bzw. Zusammensetzung der zweiten elektrisch isolierenden undotierten Diamantschicht 304 entsprechen. "In ihrer Struktur bzw. Zusammensetzung entsprechen" bedeutet beispielsweise, dass sowohl die zusätzliche undotierte Diamantschicht 307 als auch die zweite elektrisch isolierende undotierte Diamantschicht 304 mit demselben Verfahren unter den gleichen Bedingungen hergestellt worden sind, oder dass sowohl die zusätzliche undotierte Diamantschicht 307 als auch die zweite elektrisch isolierende undotierte Diamantschicht 304 die gleichen chemischen und physikalischen Eigenschaften aufweisen. Hierunter fallen beispielsweise die Schichtdicke, die Korngröße in der Diamantschicht, die chemische Zusammensetzung oder ein elektrischer Messparameter, wie etwa die elektrische Leitfähigkeit. Durch die Einbringung einer zusätzlichen undotierten Diamantschicht 307 zwischen dem Körper 302 und der ersten undotierten Diamantschicht 303 kann die Haftung zwischen der ersten undotierten Diamantschicht 303 und dem Körper 302 verbessert werden. Alternativ kann es sich bei der zusätzlichen undotierten Diamantschicht 307 um eine Schicht aus monokristallinem Diamant (MCD-Schicht) handeln. Diese MCD-Schicht kann Diamantkörner aufweisen, deren Korngröße derjenigen der Hartstoffpartikel in dem Körper 302 entspricht. Indem die zusätzliche undotierte Diamantschicht 307 einer MCD-Schicht entspricht, kann, ohne daran gebunden zu sein, eine mechanische Verkettung zwischen dem Körper 302, insbesondere eines Hartmetall-Körpers bzw. -Substrats, und der ersten undotierten Diamantschicht 303 gefördert werden, und folglich die Haftung zwischen dem Körper 302 und der ersten undotierten Diamantschicht 303 verbessert werden. Dies kann gerade im Zusammenhang mit spanabhebenden Werkzeugen zu dem Vorteil einer verbesserten Haftung, und folglich verbesserter Verschleißbeständigkeit und Standzeit führen. Ein weiterer Vorteil gegenüber der direkten Abscheidung der ersten undotierten Diamantschicht 303 auf dem Körper 302 kann sein, dass ein verstärktes Aufkohlen, welche beim Aufbringen der ersten undotierten Diamantschicht 303 aufgrund eines höheren Methangehalts in der Methan/Wasserstoff-Atmosphäre resultieren kann und den Aufbau des Diamant-Kristallgitters erschwert, gehemmt wird. Auch dieser Aspekt kann in einem haftungsoptimierten Aufbau resultieren. Selbstverständlich kann es sich bei der zusätzlichen undotierten Diamantschicht 307 auch um eine zweischichtige Schichtenfolge aus der oben beschriebenen MCD-Schicht, welche auf dem Körper 302 angeordnet ist, und einer undotierten Diamantschicht, welche in ihrer Struktur bzw. Zusammensetzung der zweiten undotierten Diamantschicht 304 entspricht und auf der MCD-Schicht angeordnet ist, handeln.

In Fig. 4 ist schematisch der beschichtete Körper 300 gemäß der zweiten Ausführungsform als ein spanabhebendes Werkzeug 400 mit einem mehrschichtig ausgebildeten Verschleißschutzschichtsystem 401 in einer Seitenansicht dargestellt. Wenn es sich bei dem beschichteten Körper 300 um ein spanabhebendes oder spanlos arbeitendes Werkzeug handelt, so handelt es sich bei dem Körper 302 um einen Werkzeugkörper 402. Das in Fig. 4 veranschaulichte spanabhebende Werkzeug 400 gemäß der zweiten Ausführungsform unterscheidet sich von dem in Fig. 2 dargestellten spanabhebenden Werkzeug 200 gemäß der ersten Ausführungsform dahingehend, dass das mehrschichtig ausgebildete Verschleißschutzschichtsystem 401 in Fig. 4 eine zusätzliche undotierte Diamantschicht 407 aufweist. Das in Fig. 4 schematisch dargestellte spanabhebende Werkzeug 400 weist auf dem Werkzeugkörper 402 auf einer verschleißbeanspruchten Funktionsfläche des Werkzeugs ein mehrschichtiges, darauf ausgebildetes Verschleißschutzschichtsystem 401 auf, welches eine zusätzliche undotierte Diamantschicht 407, eine erste elektrisch leitfähige undotierte Diamantschicht 403 und eine zweite elektrisch isolierende undotierte Diamantschicht 404 aufweist. Die zusätzliche undotierte Diamantschicht 407 kann auf dem Werkzeugkörper 402 angeordnet sein. Die erste elektrisch leitfähige undotierte Diamantschicht 403 kann auf der zusätzlichen undotierten Diamantschicht 407 angeordnet sein. Die zweite elektrisch isolierende undotierte Diamantschicht 404 kann auf der ersten elektrisch leitfähigen undotierten Diamantschicht 403 angeordnet sein. Die chemischen und physikalischen Eigenschaften, wie etwa Struktur bzw. Zusammensetzungen, der zusätzlichen undotierten Diamantschicht 407 sowie der ersten und zweiten undotierten Diamantschicht 403, 404 des in Fig. 4 dargestellten spanabhebenden Werkzeugs 400 gemäß der zweiten Ausführungsform entsprechen jeweils denen der oben im Zusammenhang mit dem beschichteten Körper 300 in Fig. 3 beschriebenen zusätzlichen undotierten Diamantschicht 307, sowie der ersten und zweiten undotierten Diamantschicht 303, 304. Hierbei entspricht die zusätzliche undotierte Diamantschicht 407 in Fig. 4 der zusätzlichen undotierten Diamantschicht 307 in Fig. 3, die erste undotierte Diamantschicht 403 in Fig. 4 der ersten undotierten Diamantschicht 303 in Fig. 3, die zweite undotierte Diamantschicht 404 in Fig. 4 der zweiten undotierten Diamantschicht 304 in Fig. 3, und das mehrschichtig ausgebildete Verschleißschutzschichtsystem 401 in Fig. 4 dem mehrschichtig ausgebildeten Verschleißschutzschichtsystem 301 in Fig. 3. Bei der zusätzlichen undotierten Diamantschicht 307 kann es sich alternativ, wie oben beschrieben, um eine MCD-Schicht handeln.

Fig. 5 zeigt schematisch einen beschichteten Körper 500 mit einem mehrschichtig ausgebildeten Verschleißschutzschichtsystem 501 gemäß einer dritten Ausführungsform in einer Seiten- oder Querschnittsansicht. Der beschichtete Körper 500 gemäß der dritten Ausführungsform unterscheidet sich von dem oben beschriebenen beschichteten Körper 100 gemäß der ersten Ausführungsform lediglich dahingehend, dass das mehrschichtig ausgebildete Verschleißschutzschichtsystem 501 eine dritte undotierte Diamantschicht 505 und eine vierte undotierte Diamantschicht 506 aufweist. Die chemischen und physikalischen Eigenschaften, wie etwa Struktur bzw. Zusammensetzungen, der ersten und zweiten undotierten Diamantschicht 503, 504 des in Fig. 5 dargestellten beschichteten Körpers 500 gemäß der dritten Ausführungsform entsprechen jeweils denen der oben im Zusammenhang mit dem in Fig. 1 dargestellten beschichteten Körper 100 gemäß der ersten Ausführungsform beschriebenen ersten und zweiten undotierten Diamantschicht 103, 104. Hierbei entspricht die erste undotierte Diamantschicht 503 in Fig. 5 der ersten undotierten Diamantschicht 103 in Fig. 1, die zweite undotierte Diamantschicht 504 in Fig. 5 der zweiten undotierten Diamantschicht 104 in Fig. 1.

Bei dem beschichteten Körper 500 gemäß der dritten Ausführungsform kann die dritte undotierte Diamantschicht 505 auf der zweiten undotierten Diamantschicht 504 angeordnet sein und die vierte undotierte Diamantschicht 506 kann auf der dritten undotierten Diamantschicht 505 angeordnet sein. Die dritte undotierte Diamantschicht 505 kann die gleiche Struktur bzw. Zusammensetzung wie die erste Diamantschicht 503 aufweisen. Die vierte undotierte Diamantschicht 506 kann die gleiche Struktur bzw. Zusammensetzung wie die zweite Diamantschicht 504 aufweisen. Für den Begriff "die gleiche Struktur bzw. Zusammensetzung aufweisen" gilt dasselbe, wie im Zusammenhang mit der ersten Ausführungsform erläutert. In dem Verschleißschutzschichtsystem 501 gemäß der dritten Ausführungsform kann sich folglich aufgrund einer solchen Schichtanordnung, von der Stapelrichtung aus gesehen, die vierte undotierte Diamantschicht 506 an der vom Körper 502 entferntesten Position im Verschleißschutzschichtsystem 501 befinden. Mit anderen Worten kann die vierte undotierte Diamantschicht 506 in dem Verschleißschutzschichtsystem 501 gemäß der dritten Ausführungsform aufgrund einer solchen Schichtanordnung bei der Anwendung des beschichteten Körpers 500, beispielsweise - wenn es sich bei dem beschichteten Körper 500 um ein Werkzeug 600 handelt - bei der Bearbeitung eines Werkstücks, in direktem Kontakt mit dem Werkstück sein. Durch das Einbringen weiterer Schichten wie der dritten und vierten Diamantschicht 505, 506 wird die Festigkeit und Härte des Verschleißschutzschichtsystems 501 und folglich die Verschleißbeständigkeit des beschichteten Körpers 500 zusätzlich erhöht. Zudem ermöglicht ein mehrschichtiger Aufbau des Verschleißschutzschichtsystems aus wenigstens zwei elektrisch leitfähigen undotierten Diamantschichten eine kontinuierliche Erfassung des Verschleißgrades bzw. der Abnutzung des beschichteten Körpers bzw. des Verschleißschutzschichtsystems bei der Bearbeitung eines Werkstücks im laufenden Betrieb, indem ein oben genannter elektrischer Messparameter bzw. dessen Änderung beispielsweise im einfachsten Fall in einer Messkette aus zwei undotierten elektrisch leitfähigen Diamantschichten, kontinuierlich oder periodisch erfasst wird.

In Fig. 6 ist schematisch der beschichtete Körper 500 gemäß der dritten Ausführungsform als ein spanabhebendes Werkzeug 600 mit einem mehrschichtig ausgebildeten Verschleißschutzschichtsystem 601 in einer Seitenansicht dargestellt. Wenn es sich bei dem beschichteten Körper 500 um ein spanabhebendes oder spanlos arbeitendes Werkzeug handelt, so handelt es sich bei dem Körper 502 um einen Werkzeugkörper 602. Das in Fig. 6 veranschaulichte spanabhebende Werkzeug 600 unterscheidet sich von dem in Fig. 2 dargestellten spanabhebenden Werkzeug 200 dahingehend, dass das mehrschichtig ausgebildete Verschleißschutzschichtsystem 601 in Fig. 6 zusätzlich eine dritte elektrisch leitfähige undotierte Diamantschicht 605 und eine vierte elektrisch isolierende undotierte Diamantschicht 606 aufweist. Das in Fig. 6 schematisch dargestellte spanabhebende Werkzeug 600 weist auf dem Werkzeugkörper 602 auf einer verschleißbeanspruchten Funktionsfläche des Werkzeugs ein mehrschichtiges, darauf ausgebildetes Verschleißschutzschichtsystem 601 auf, welches eine erste elektrisch leitfähige undotierte Diamantschicht 603, eine zweite elektrisch isolierende undotierte Diamantschicht 604, eine dritte elektrisch leitfähige undotierte Diamantschicht 605 und eine vierte elektrisch isolierende undotierte Diamantschicht 606 aufweist. Die erste elektrisch leitfähige undotierte Diamantschicht 603 kann auf dem Werkzeugkörper 602 angeordnet sein. Die zweite elektrisch isolierende undotierte Diamantschicht 604 kann auf der ersten elektrisch leitfähigen undotierten Diamantschicht 603 angeordnet sein. Die dritte elektrisch leitfähige undotierte Diamantschicht 605 kann auf der zweiten elektrisch isolierenden undotierten Diamantschicht 604 angeordnet sein. Die vierte elektrisch isolierende undotierte Diamantschicht 606 kann auf der dritten elektrisch leitfähigen undotierten Diamantschicht 605 angeordnet sein. Die chemischen und physikalischen Eigenschaften, wie etwa Struktur bzw. Zusammensetzungen, der ersten, zweiten, dritten und vierten undotierten Diamantschicht 603, 604, 605, 606 des in Fig. 6 dargestellten spanabhebenden Werkzeugs 600 gemäß der dritten Ausführungsform entsprechen jeweils denen der oben im Zusammenhang mit dem in Fig. 5 dargestellten beschichteten Körper 500 gemäß der dritten Ausführungsform beschriebenen ersten, zweiten, dritten und vierten undotierten Diamantschicht 503, 504, 505, 506.

Fig. 7 zeigt schematisch einen beschichteten Körper 700 mit einem mehrschichtig ausgebildeten Verschleißschutzschichtsystem 701 gemäß einer vierten Ausführungsform in einer Seiten- oder Querschnittsansicht. Der in Fig. 7 dargestellte beschichtete Körper 700 gemäß der vierten Ausführungsform unterscheidet sich von dem oben im Zusammenhang mit Fig. 3 beschriebenen beschichteten Körper 300 gemäß der zweiten Ausführungsform lediglich dahingehend, dass das mehrschichtig ausgebildete Verschleißschutzschichtsystem 701 zusätzlich eine dritte elektrisch leitfähige undotierte Diamantschicht 705 und eine vierte elektrisch isolierende undotierte Diamantschicht 706 aufweist. Die chemischen und physikalischen Eigenschaften, wie etwa Struktur bzw. Zusammensetzungen, der zusätzlichen undotierten Diamantschicht 707, sowie der ersten und zweiten undotierten Diamantschicht 703, 704 aus Fig. 7 entsprechen jeweils denen der oben im Zusammenhang mit der zweiten Ausführungsform in Fig. 3 beschriebenen zusätzlichen undotierten Diamantschicht 307, und der ersten und zweiten undotierten Diamantschicht 303, 304. Zudem entspricht die Anordnung sowie die chemischen und physikalischen Eigenschaften, wie etwa Struktur bzw. Zusammensetzungen, der dritten elektrisch leitfähigen undotierten Diamantschicht 705 und der vierten elektrisch isolierenden undotierten Diamantschicht 706 aus Fig. 7 jeweils denen der oben im Zusammenhang mit der dritten Ausführungsform in Fig. 5 beschriebenen dritten elektrisch leitfähigen undotierten Diamantschicht 505 und der vierten elektrisch isolierenden undotierten Diamantschicht 506.

In Fig. 8 ist schematisch der beschichtete Körper 700 gemäß der vierten Ausführungsform als ein spanabhebendes Werkzeug 800 mit einem mehrschichtig ausgebildeten Verschleißschutzschichtsystem 801 in einer Seitenansicht dargestellt. Wenn es sich bei dem beschichteten Körper 700 um ein spanabhebendes oder spanlos arbeitendes Werkzeug handelt, so handelt es sich bei dem Körper 702 um einen Werkzeugkörper 802. Das in Fig. 8 veranschaulichte spanabhebende Werkzeug 800 unterscheidet sich von dem oben im Zusammenhang mit Fig. 4 beschriebenen spanabhebenden Werkzeug 400 gemäß der zweiten Ausführungsform lediglich dahingehend, dass das mehrschichtig ausgebildete Verschleißschutzschichtsystem 801 zusätzlich eine dritte elektrisch leitfähige undotierte Diamantschicht 805 und eine vierte elektrisch isolierende undotierte Diamantschicht 806 aufweist. Die Anordnung, sowie die chemischen und physikalischen Eigenschaften, wie etwa Struktur bzw. Zusammensetzungen, der zusätzlichen undotierten Diamantschicht 807, sowie der ersten, zweiten, dritten und vierten undotierten Diamantschicht 803, 804, 805, 806 aus Fig. 8 entsprechen jeweils denen der oben im Zusammenhang mit dem beschichteten Körper 700 gemäß der vierten Ausführungsform in Fig. 7 beschriebenen zusätzlichen undotierten Diamantschicht 707, und der ersten, zweiten, dritten und vierten undotierten Diamantschicht 703, 704, 705, 706.

Die vorliegende Anmeldung umfasst auch Modifikationen der ersten, zweiten, dritten und vierten Ausführungsform, welche nicht vom Kern der Erfindung abweichen. Beispielsweise kann ein beschichteter Körper 500, 700 mit einem mehrschichtig ausgebildeten Verschleißschutzschichtsystem 501, 701 gemäß der dritten oder vierten Ausführungsform zusätzlich zu der ersten, zweiten, dritten und vierten undotierten Diamantschicht 503, 504, 505, 506, 703, 704, 705, 706 noch wenigstens ein weiteres Schichtpaar, welches zwei undotierte Diamantschichten aufweist, umfassen, wobei die zwei undotierten Diamantschichten in ihrer Anordnung und Struktur bzw. Zusammensetzung der ersten und zweiten undotierten Diamantschicht 503, 504, 703, 704 entsprechen. Beispielsweise wäre in dem Fall eines weiteren Schichtpaares eine fünfte undotierte Diamantschicht auf der vierten undotierten Diamantschicht 506, 706, und eine sechste undotierte Diamantschicht, welche auf der fünften undotierten Diamantschicht angeordnet ist, denkbar. Ungeachtet dessen kann bei Bedarf in der ersten, zweiten, dritten oder vierten Ausführungsform das mehrschichtig ausgebildete Verschleißschutzschichtsystem 101, 301, 501, 701 eine oder mehrere weitere Schicht(en), beispielsweise zwischen der ersten und zweiten undotierten Diamantschicht 103, 104, 303, 304, 503, 504, 703, 704, aufweisen. Bei Bedarf kann der beschichtete Körper 100, 300, 500, 700 neben dem mehrschichtig ausgebildeten Verschleißschutzschichtsystem 101, 301, 501, 701 eine oder mehrere weitere Schicht(en), beispielsweise unter oder auf dem mehrschichtig ausgebildeten Verschleißschutzschichtsystem 101, 301, 501, 701 aufweisen. Beispielsweise kann es sich bei den in den obigen Modifikationen genannten weiteren Schichten, beispielsweise im Rahmen des Schichtpaares, um Diamantschichten oder Keramikschichten handeln.

Weiterhin betrifft die vorliegende Erfindung ein Verfahren zur Herstellung eines beschichteten Körpers gemäß einer der oben beschriebenen Ausführungsformen. Das Verfahren umfasst das Aufbringen eines mehrschichtig ausgebildeten Verschleißschutzschichtsystems auf eine verschleißbeanspruchte Funktionsfläche eines Körpers aus Metall, einem metallkeramischen Verbund oder Keramik mittels chemischer Dampfabscheidung (CVD) aus einer Methan/Wasserstoff-Atmosphäre in einer CVD-Kammer. Das Aufbringen eines mehrschichtig ausgebildeten Verschleißschutzschichtsystems kann das Aufbringen einer ersten elektrisch leitfähigen undotierten Diamantschicht auf eine verschleißbeanspruchte Funktionsfläche eines Körpers aus Metall, einem metallkeramischen Verbund oder Keramik mittels chemischer Dampfabscheidung (CVD) aus einer Methan/Wasserstoff-Atmosphäre in einer CVD-Kammer, und das Aufbringen einer zweiten elektrisch isolierenden undotierten Diamantschicht auf die erste undotierte Diamantschicht mittels chemischer Dampfabscheidung (CVD) aus einer Methan/Wasserstoff-Atmosphäre in einer CVD-Kammer umfassen.

Der Ablauf eines Verfahrens zur chemischen Dampfphasenabscheidung (CVD) ist dem Fachmann grundsätzlich bekannt. Beispiele für ein Verfahren zur chemischen Dampfphasenabscheidung (CVD) können das Heißdrahtverfahren (hot filament CVD oder HF-CVD), das Mikrowellenplasmaverfahren (microwave plasma CVD, MWP-CVD) oder das Plasma-Jet-Verfahren umfassen. Die Verfahren unterscheiden sich durch die Menge der aktivierten Spezies und damit durch Beschichtungsgeschwindigkeit und Schichtqualität, beschichtbare Oberfläche und Geometrie sowie Skalierbarkeit. Hierbei bietet das HF-CVD-Verfahren beispielsweise im Vergleich zum Plasmaverfahren die größte Flexibilität bei geringeren Beschichtungstemperaturen. Die Drähte können an die unterschiedlichen Geometrien der zu beschichtenden Körper angepasst werden, da für den Schichtaufbau ein bestimmter Abstand zu den heißen Drähten eingehalten werden muss, welcher typischerweise im Bereich von ca. 5 mm bis 30 mm liegt. Im Rahmen der vorliegenden Erfindung ist es grundsätzlich bevorzugt, dass das Aufbringen eines mehrschichtig ausgebildeten Verschleißschutzschichtsystems als Heißdrahtverfahren durchgeführt wird, wobei vorzugsweise ein Wolfram (W)-Draht eingesetzt wird.

Wie oben erwähnt erfolgt das Aufbringen der Diamantschichten im mehrschichtig ausgebildeten Verschleißschutzschichtsystems in einer CVD-Kammer mittels chemischer Dampfabscheidung (CVD) aus einer Methan/Wasserstoff-Atmosphäre. Die Methan/Wasserstoff-Atmosphäre kann durch Einleiten von Materialgas, welches die vorbestimmte Zusammensetzung der entsprechenden Komponenten, zumindest allerdings Wasserstoff im molaren Überschuss zu Methan, enthält, in eine Vakuumkammer erzeugt werden. Beim Einleiten wird das Materialgas in der Regel in einen Zustand angeregt, welcher Plasma oder Radikale enthält. Beispielsweise kann im HF-CVD-Verfahren das Materialgas durch Kontakt mit dem heißen Filament derart erhitzt werden, dass sich Wasserstoff in Wasserstoffradikale aufspaltet und diese im weiteren Reaktionsverlauf mit Methan reagieren um letztlich die Ausbildung einer Diamantschicht zu ermöglichen. Das entsprechend angeregte Materialgas wird zum Aufbringen des mehrschichtig ausgebildeten Verschleißschutzschichtsystems bzw. der verschiedenen individuellen Schichten genutzt.

Bevorzugt erfolgt das Aufbringen des mehrschichtig ausgebildeten Verschleißschutzschichtsystems durch Zumischen von Wasserstoff im molaren Überschuss zu Methan in einer CVD-Kammer, wobei eine Beschichtungstemperatur von 650°C bis 750°C und ein Beschichtungsdruck von 1 mbar bis 10 mbar bzw. 1 hPa bis 10 hPa eingestellt wird. Besonders bevorzugt erfolgt das Aufbringen einer ersten undotierten Diamantschicht unter den Bedingungen von einer höheren Methankomposition, vorzugsweise wobei Methan zwischen 5% und 7% enthalten ist (CH₄-Massenstrom von 75 sccm bis 105 sccm), und höherer Prozesstemperatur, vorzugsweise zwischen 700°C und 750°C, und das Aufbringen einer zweiten undotierten Diamantschicht unter der Bedingung von einer niedrigeren Methankomposition, vorzugsweise wobei Methan zwischen 1,3% und 3% enthalten ist (CH₄-Massenstrom von 20 sccm bis 45 sccm). Die Temperatur der Filamente kann in einem Bereich von 1800 bis 2200 °C, bevorzugt aber bei etwa 2000°C liegen. Die Entfernung der Filamente zum zu beschichtenden Körper kann zwischen 3 mm und 10 mm liegen, bevorzugt aber 5 mm betragen. Die Methan/Wasserstoff-Atmosphäre kann durch Zuführen von H₂/CH₄ als Materialgas erzeugt werden. Hierbei kann das Materialgas durch die eingesetzten Massenströme eingestellt werden. Der H₂-Massenstrom kann in einem Bereich von 1000 sccm und 3000 sccm liegen. Besonders bevorzugt ist es, wenn das Aufbringen der ersten undotierten Diamantschicht bei einem H₂-Massenstrom in einem Bereich von 1000 sccm und 1500 sccm erfolgt und das Aufbringen der zweiten undotierten Diamantschicht bei einem H₂-Massenstrom in einem Bereich von 1500 sccm und 3000 sccm erfolgt. Der CH₄-Massenstrom kann in einem Bereich von 20 sccm und 105 sccm liegen. Dies entspricht einem CH₄-Gehalt in der Methan/WasserstoffAtmosphäre in einem Bereich von 1,3% bis 7%. Besonders bevorzugt ist es, wenn das Aufbringen der ersten undotierten Diamantschicht bei einem CH₄-Massenstrom in einem Bereich von 75 sccm und 105 sccm (CH₄-Gehalt in der Methan/Wasserstoff-Atmosphäre in einem Bereich von 5% bis 7%) erfolgt, und das Aufbringen der zweiten undotierten Diamantschicht bei einem CH₄-Massenstrom in einem Bereich von 20 sccm und 45 sccm (CH₄-Gehalt in der Methan/Wasserstoff-Atmosphäre in einem Bereich von 1,3% bis 3%) erfolgt. Neben oder anstelle von Methan können im Rahmen der oben besprochenen Aspekte selbstverständlich auch für CVD-Verfahren geeignete andere Kohlenstoffhaltige Gase, insbesondere, Ethan, Ethylen oder Acetylen, Anwendung finden. Die Beschichtungsdauer kann je nach benötigter Schichtdicke der einzelnen Schichten variiert werden. In der Regel kann die Beschichtungsdauer 15 h bis 30 h betragen. Besonders bevorzugt ist es, wenn die Beschichtungsdauer für das Aufbringen der ersten undotierten Diamantschicht 15 h bis 20 h beträgt, und die Beschichtungsdauer für das Aufbringen der zweiten undotierten Diamantschicht 15 h bis 50 h beträgt. Die Beschichtungstemperatur, also die Temperatur des zu beschichtenden Körpers, kann zwischen 600°C und 1000°C, bevorzugt zwischen 650°C und 750°C betragen. Besonders bevorzugt ist es, wenn die Beschichtungstemperatur für das Aufbringen der ersten undotierten Diamantschicht zwischen 700°C und 750°C, und die Beschichtungstemperatur für das Aufbringen der zweiten undotierten Diamantschicht 650°C und 700°C beträgt. Der Beschichtungsdruck in der CVD-Kammer kann zwischen 1 hPa und 10 hPa betragen. Besonders bevorzugt ist es, wenn der Beschichtungsdruck für das Aufbringen der ersten undotierten Diamantschicht zwischen 1 hPa und 5 hPa, und der Beschichtungsdruck für das Aufbringen der zweiten undotierten Diamantschicht zwischen 5 hPa und 10 hPa beträgt. Die Beschichtungsraten können beim HF-CVD-Verfahren typischerweise zwischen 0,05 µm/h und 3 µm/h betragen. Besonders bevorzugt ist es, wenn die Beschichtungsrate für das Aufbringen der ersten undotierten Diamantschicht zwischen 0,05 µm/h und 0,1 µm/h, und die Beschichtungsrate für das Aufbringen der zweiten undotierten Diamantschicht 0,2 µm/h und 0,3 µm/h liegt.

Bei Bedarf kann vor dem Aufbringen der ersten undotierten Diamantschicht zuerst das Aufbringen einer zusätzlichen undotierten Diamantschicht auf eine verschleißbeanspruchte Funktionsfläche des Körpers mittels chemischer Dampfabscheidung (CVD) aus einer Methan/Wasserstoff-Atmosphäre in einer CVD-Kammer erfolgen. Die zusätzliche undotierte Diamantschicht entspricht der oben im Rahmen der Beschreibung des mehrschichtig ausgebildeten Verschleißschutzschichtsystems beschriebenen zusätzlichen undotierten Diamantschicht, und es können die entsprechend oben beschriebenen Verfahrensbedingungen für das Aufbringen Anwendung finden. Mit anderen Worten, gegeben dem Fall, dass die zusätzliche undotierte Diamantschicht die gleiche Struktur bzw. Zusammensetzung der zweiten undotierten Diamantschicht aufweisen soll, so sind die entsprechend oben beschriebenen Verfahrensbedingungen für das Aufbringen anzuwenden. In diesem Fall erfolgt anschließend das Aufbringen der ersten undotierten Diamantschicht auf die zusätzliche undotierte Diamantschicht mittels chemischer Dampfabscheidung (CVD) aus einer Methan/Wasserstoff-Atmosphäre in einer CVD-Kammer. Alternativ kann es sich wie oben ausgeführt bei der zusätzlichen undotierten Diamantschicht um eine MCD-Schicht handeln. In diesem Fall kann das Aufbringen der MCD-Schicht auf eine verschleißbeanspruchte Funktionsfläche des Körpers mittels chemischer Dampfabscheidung (CVD) aus einer Methan/Wasserstoff-Atmosphäre in einer CVD-Kammer erfolgen, wobei der Methangehalt in der Methan/Wasserstoff-Atmosphäre niedrig, vorzugsweise zwischen 1% und 1,5% (CH₄-Massenstrom von 15 sccm bis 25 sccm), liegt. Durch das Aufbringen dieser MCD-Schicht ergeben sich die oben im Rahmen der Beschreibung der MCD-Schicht aufgeführten Vorteile, beispielsweise einer verbesserten Haftung, und - im Falle von spanabhebenden Werkzeugen - verbesserter Verschleißbeständigkeit und Standzeit. Sofern es sich bei der zusätzlichen undotierten Diamantschicht, wie oben beschrieben, um eine zweischichtige Schichtenfolge aus der oben beschriebenen MCD-Schicht, welche auf dem Körper angeordnet ist, und einer undotierten Diamantschicht, welche in ihrer Struktur bzw. Zusammensetzung der zweiten undotierten Diamantschicht entspricht und auf der MCD-Schicht angeordnet ist, handelt, ist das Verfahren um die jeweiligen Schritte zum Aufbringen der jeweiligen Schichten mit den entsprechend oben beschriebenen Verfahrensbedingungen zu ergänzen.

Bei Bedarf kann vor dem Aufbringen der zweiten undotierten Diamantschicht zuerst das Aufbringen einer oder mehrerer weiteren/weiterer Schicht(en), bevorzugt mittels chemischer Dampfabscheidung (CVD) aus einer Methan/Wasserstoff-Atmosphäre in einer CVD-Kammer, auf die erste undotierte Diamantschicht erfolgen. Diese eine oder mehreren weitere(n) Schicht(en) entspricht/entsprechen der oben im Rahmen der Beschreibung der Modifikationen des mehrschichtig ausgebildeten Verschleißschutzschichtsystems beschriebenen einen oder mehreren weiteren Schicht(en), und es können die entsprechend oben beschriebenen Verfahrensbedingungen für das Aufbringen Anwendung finden.

Bei Bedarf kann nach dem Aufbringen der zweiten undotierten Diamantschicht das Aufbringen einer dritten undotierten Diamantschicht und einer vierten undotierten Diamantschicht mittels chemischer Dampfabscheidung (CVD) aus einer Methan/Wasserstoff-Atmosphäre in einer CVD-Kammer erfolgen. Vorzugsweise kann die dritte undotierte Diamantschicht auf der zweiten undotierten Diamantschicht aufgebracht werden und die vierte undotierte Diamantschicht kann auf der dritten undotierten Diamantschicht aufgebracht werden. Die dritte undotierte Diamantschicht und die vierte undotierte Diamantschicht entsprechen hierbei der oben im Rahmen der Beschreibung des mehrschichtig ausgebildeten Verschleißschutzschichtsystems beschriebenen dritten und vierten undotierten Diamantschicht. Entsprechend können die oben beschriebenen Verfahrensbedingungen für das Aufbringen Anwendung finden. Mit anderen Worten, gegeben dem Fall, dass die dritte undotierte Diamantschicht der ersten undotierten Diamantschicht entspricht und/oder die vierte undotierte Diamantschicht der zweiten undotierten Diamantschicht entspricht, so können die entsprechend oben beschriebenen Verfahrensbedingungen für das Aufbringen Anwendung finden.

Bei Bedarf kann vor dem Aufbringen der ersten undotierten Diamantschicht die Substratoberfläche des Körpers beispielsweise durch Bestäuben mit Diamantpulver vorbekeimt werden. Dies kann durch einen ultraschallunterstützenden Bekeimungsprozess, vorzugsweise unter Verwendung einer 2,5%-igen NanoAmando^{®}-Lösung erfolgen. Hierbei kann der Bekeimungsprozess durch Eintauchen des Körpers in eine 2,5%-igen NanoAmando^{®}-Lösung, vorzugsweise für etwa 10 min erfolgen. Ein solcher ultraschallunterstützender Bekeimungsprozess kann, wenn es sich bei dem Körper um ein spanabhebendes oder spanlos arbeitendes Werkzeug handelt, ebenso für eine Bekeimung des Werkzeugkörpers angewendet werden.

Bei Bedarf kann vor dem Aufbringen der ersten undotierten Diamantschicht eine Vorbehandlung der zu beschichtenden Funktionsfläche eines Körpers, beispielsweise durch Ätzen der zu beschichtenden Funktionsfläche des Körpers mittels einer Murakami-Lösung und/oder Peroxomonoschwefelsäure (H₂SO₅; Caro's Acid), erfolgen. Bei einer Murakami-Lösung handelt es sich in der Regel um eine Lösung von K₃[Fe(CN)₆] in KOH. Bevorzugt wird eine solche Vorbehandlung bei einem Körper aus Hartmetall, welcher beispielsweise auch Hartstoffpartikel, z.B. WC-Körner, die in einer cobalthaltigen Bindematrix eingebettet sind, enthält, durchgeführt. Durch einen solchen Vorbehandlungschritt kann der Gehalt an Cobalt im Oberflächenbereich des Substrats des Körpers verringert werden. Ohne daran gebunden zu sein, kann hierdurch die bekannte katalytische Wirkung für die Rückwandlung der kubischen Diamantphase in die hexagonale graphitische Phase verringert werden, so dass die kubischen Diamantkristalle hinreichend Zeit haben, auf der Substratoberfläche aufzuwachsen, ohne dass eine in situ Re-Konversion in Graphit erfolgt. Folglich kann durch einen derartigen Vorbehandlungsschritt eine verbesserte Nukleation der Diamantkörner bei Abscheidungsanfang gewährleitest werden, indem eine Graphitierung gehemmt wird. Ein weiterer Vorteil hiervon ist, dass durch einen derartigen Vorbehandlungsschritt die Haftung der ersten undotierten Diamantschicht auf dem Körper, insbesondere aus Hartmetall, verbessert wird.

Durch das Ausbleiben einer Dotierung bei der Abscheidung zumindest der ersten und zweiten Diamantschicht aus einer Methan/Wasserstoff-Atmosphäre in einer CVD-Kammer ist es bei dem erfindungsgemäßen Verfahren nicht notwendig ein Dotiergas beizumischen. Demzufolge wird apparativ wie verfahrenstechnisch eine einfachere und kostengünstigere Herstellung des beschichteten Körpers ermöglicht.

Durch die oben beschriebenen Verfahrensbedingungen, und insbesondere betreffend die Beschichtungstemperatur, den Beschichtungsdruck sowie die Methan/Wasserstoff-Atmosphäre, und hier insbesondere die H₂/CH₄-Massenströme, kann eine erste undotierte Diamantschicht erzeugt bzw. aufgebracht werden, welche die im Rahmen der Eigenschaften oben beschriebene nanokristalline Struktur aufweist und n-leitfähig ist. Durch Integration dieser ersten undotierten Diamantschicht im Rahmen eines mehrschichtig ausgebildeten Verschleißschutzschichtsystems kann der oben beschriebene beschichtete Körper mit einem auf einer verschleißbeanspruchten Funktionsfläche des Körpers mehrschichtig ausgebildeten Verschleißschutzschichtsystem gemäß der ersten, zweiten, dritten oder vierten Ausführungsform, sowie deren oben beschriebenen Modifikationen, hergestellt werden. Dieser weist die Vorteile einer Diamantbeschichtung, wie beispielsweise die Erhöhung der Verschleißbeständigkeit gegenüber abrasiver Beanspruchung, auf. Zudem ist die Verschleißerfassung mittels eines elektrischen Parameters nicht auf eine Dotierung angewiesen.

Wie bereits erwähnt, findet die vorliegende Erfindung insbesondere Anwendung an einem spanlos oder spanabhebend arbeitenden Werkzeug, wobei das gesamte Werkzeug oder ein Teil des Werkzeugs, zum Beispiel ein Schneidteil, den Körper bildet. Durch die Verwendung des erfindungsgemäßen beschichteten Körpers kann sich der Vorteil ergeben, dass die Erfassung des Verschleißgrades eines Körpers bei der Bearbeitung eines Werkstücks auf der Grundlage des Verschleißes des Verschleißschutzschichtsystems effizient und einfach ermöglicht werden kann ohne auf die Vorteile einer Diamantbeschichtung wie beispielsweise die Erhöhung der Verschleißfestigkeit verzichten zu müssen und gleichzeitig nicht auf eine Dotierung der Diamantschicht bei der Verschleißerfassung, beispielsweise mittels eines elektrischen Parameters, angewiesen zu sein. Gerade im Zusammenhang mit der Verwendung eines beschichteten Körpers gemäß der dritten oder vierten Ausführungsform kann sich somit bei der Bearbeitung eines Werkstücks die Verschleißerfassung über eine Messkette bestehend aus Körper und Werkstück erübrigen, da die Verschleißerfassung ausschließlich innerhalb des beschichteten Körpers erfolgen kann. Dies kann den Vorteil aufweisen, dass die Verschleißerfassung auch bei nichtleitenden Werkstücken angewendet werden kann. Zudem kann dem Anwender ein sichereres Arbeiten bei der Erfassung ermöglicht werden.

Ungeachtet der Tatsache, dass die Beschreibung im Rahmen der vorliegenden Erfindung auf einen Körper gerichtet ist, kann die vorliegende Lehre ebenso auf einen anderen Gegenstand anstelle eines Körpers übertragen werden. Beispielsweise kann das oben beschriebene Verschleißschutzschichtsystem ebenso auf Gegenstände bzw. Systeme aufgebracht werden, deren einander gegenüberliegende Oberflächen in Reibkontakt stehen und somit Reibungskräften ausgesetzt sind. In dieser Hinsicht soll beispielsweise die Anwendung bei Gleitlagern und deren Lagerflächen oder Bremsscheiben im Automobil miteinbezogen werden. Zudem kann sich die vorliegende Anmeldung auf Verschleißteile aus Metall, einem metallkeramischen Verbund oder Keramik erstrecken. Hierbei sollen vor allem spanabhebende oder spanlos arbeitende Werkzeuge miteinbezogen sein.

### Herstellungsbeispiele der ersten und zweiten Ausführungsform

Ein Hartmetallspiralbohrer aus einem 10M%Co-Hartmetall mit einer mittleren WC-Korngröße von 0,6 µm (Gühring-Handelsname DK460UF) wurde für die Beschichtung vorbehandelt, indem zunächst ein Ätzschritt zum Entfernen von Cobalt aus der Oberfläche unter Verwendung von Murakami-Lösung und Caro's Acid durchgeführt wurde. Anschließend erfolgte ein ultraschallunterstützter Bekeimungsprozess durch Eintauchen in 2,5%-ige NanoAmando^{®}-Lösung für 10 min. Der hierdurch erhaltene vorbehandelte Körper bzw. Werkzeugkörper wurde in die Vakuumkammer einer handelsüblichen Heißdraht-CVD-Anlage (CemeCon CC800/Dia) eingebracht. Die Wolframdrähte (99,99% Reinheit, Ø0,147 µm) der CVD-Anlage waren in einem Abstand von ca. 10 mm parallel zueinander angeordnet. Der eingebrachte Körper bzw. Werkzeugkörper war parallel zu dessen Längsachse von zwei Filamentrahmen umgeben. Die Temperatur der Filamente wurde auf ca. 2000°C eingestellt und mittels optischer Thermometer überprüft. Die Entfernung der Filamente zum zu beschichtenden Körper bzw. Werkzeugkörper betrug 5 mm. Anschließend wurde die erste elektrisch leitfähige undotierte Diamantschicht auf der Oberfläche des Körpers bzw. Werkzeugkörpers durch Zuführen von H₂/CH₄ als Materialgas abgeschieden und daraufhin unter Änderung der Verfahrensbedingungen im laufenden Betrieb die zweite elektrisch isolierende undotierte Diamantschicht auf der ersten undotierten Diamantschicht abgeschieden. Bei Bedarf wurde vor der Abscheidung der ersten undotierten Diamantschicht eine zusätzliche undotierte Diamantschicht abgeschieden. Tabelle 1 zeigt Verfahrensbedingungen (A bis I) jeweils für die Abscheidung der ersten elektrisch leitfähigen undotierten Diamantschicht (Verfahrungsbedingungen A, B oder C) und zweiten elektrisch isolierenden undotierten Diamantschicht (Verfahrensbedingungen D, E, F, G oder H), sowie der zusätzlichen undotierten Diamantschicht (Verfahrensbedingungen I). Zudem sind die sich hieraus jeweils ergebende Schichtdicke und elektrische Leitfähigkeit angegeben.

**Tabelle 1: Verfahrensbedingungen (I, A, B, C, D, E, F, G bzw. H) für Abscheidungen der ersten und zweiten undotierten Diamantschicht, sowie der zusätzlichen undotierten Diamantschicht.**

| Herstelllungsbeispiele 1 - 30 | | H₂-Massenstrom [sccm] | CH₄-Massenstrom [sccm] | Beschichtungstemperatur [°C] | Druck [hPa] | Beschichtungszeit [h] | Schichtdicke [µm] | Korngröße [nm] | Elektrische Leitfähigkeit [S/cm] |
|---|---|---|---|---|---|---|---|---|---|
| Zusätzliche undotierte Diamantschicht | I | 1500 | 22 | 650 | 5 | 4 | 1 | 113,4 | 3,3×10⁻⁸ |
| Erste elektrisch leitfähige undotierte Diamantschicht | A | 1500 | 105 | 700 | 5 | 17 | 1 | 5,3 | 10,13 |
| | B | 2000 | 92 | 700 | 9 | 19 | 1 | 5,9 | 10,01 |
| | C | 1500 | 100 | 750 | 3 | 15 | 1 | 4,8 | 11,78 |
| Zweite elektrisch isolierende undotierte Diamantschicht | D | 1500 | 44 | 650 | 5 | 40 | 8 | 20,7 | 5,4×10⁻⁶ |
| | E | 1500 | 45 | 700 | 3 | 32 | 8 | 15,1 | 9,8×10⁻⁶ |
| | F | 2000 | 42 | 650 | 9 | 35 | 8 | 32,4 | 2,1×10⁻⁶ |
| | G | 1500 | 20 | 650 | 5 | 10 | 3 | 138,7 | 9,2×10⁻⁹ |
| | H | 1500 | 25 | 700 | 9 | 15 | 5 | 118,6 | 1,4×10⁻⁸ |

"sccm" steht hierbei für Standardkubikzentimeter pro Minute. Unabhängig von Druck und Temperatur wird somit dieser Einheit eine definierte strömende Gasmenge pro Zeiteinheit beschrieben, also ein Massenstrom angegeben. Der Standardkubikzentimeter ist dabei ein Gasvolumen von V = 1 cm³ unter Normbedingungen (T = 0°C und p = 1013,25 hPa), den sog. physikalischen Normbedingungen nach DIN 1343.

Die Zusammenfassung der individuellen Verfahrensbedingungen A bis I innerhalb von Tabelle 1 dient lediglich der besseren Darstellbarkeit. Im Rahmen der Herstellung eines Körpers bzw. Werkzeugs mit einem mehrschichtig ausgebildeten Verschleißschutzschichtsystem gemäß der ersten Ausführungsform ist es möglich die individuellen Verfahrensbedingungen A bis C bzw. D bis H für die erste undotierte Diamantschicht und zweite undotierte Diamantschicht beliebig zu kombinieren. Hierfür werden die in der Tabelle 1 angegebenen Verfahrensbedingungen für die Abscheidung der ersten bzw. zweiten undotierten Diamantschicht im oben beschriebenen Herstellungsbeispiel entsprechend angewendet. Mit anderen Worten könnten beispielweise für die Herstellung eines Körpers bzw. eines Werkzeugs mit einem mehrschichtig ausgebildeten Verschleißschutzschichtsystem gemäß der ersten Ausführungsform die Verfahrensbedingungen A und F angewendet werden, um zunächst eine erste elektrisch leitfähige undotierte Diamantschicht auf der Oberfläche des Körpers bzw. Werkzeugkörpers gemäß Verfahrensbedingungen A abzuscheiden und daraufhin eine zweite elektrisch isolierende undotierte Diamantschicht gemäß Verfahrensbedingungen F auf der ersten undotierten Diamantschicht abzuscheiden. Hieraus ergeben sich beispielsweise die folgenden Herstellungsbeispiele 1 bis 15 für einen Körper bzw. ein Werkzeug mit einem mehrschichtig ausgebildeten Verschleißschutzschichtsystem gemäß der ersten Ausführungsform, wobei die sich durch Anwendung der Verfahrensbedingungen ergebenden Schichten jeweils mit den den Verfahrensbedingungen entsprechenden Buchstaben bezeichnet sind:

**Tabelle 2: Herstellungsbeispiele 1 bis 15 und Schichtenfolgen.**

| Herstellungsbeispiel | Schichtenfolge |
|---|---|
| 1 | AD |
| 2 | AE |
| 3 | AF |
| 4 | AG |
| 5 | AH |
| 6 | BD |
| 7 | BE |
| 8 | BF |
| 9 | BG |
| 10 | BH |
| 11 | CD |
| 12 | CE |
| 13 | CF |
| 14 | CG |
| 15 | CH |

Wie oben erwähnt kann bei Bedarf durch Anwendung der Verfahrensbedingungen I aus Tabelle 1 eine zusätzliche undotierte Diamantschicht abgeschieden werden, um einen beschichteten Körper bzw. ein Werkzeug gemäß der zweiten Ausführungsform herzustellen. Da diese Verfahrensbedingungen I mit den anderen Verfahrensbedingungen A bis C bzw. D bis H der ersten bzw. zweiten undotierten Diamantschicht kombiniert werden können, ergeben sich zusätzlich zu den in Tabelle 2 dargestellten Herstellungsbeispielen 1 bis 15 weitere Herstellungsbeispiele 16 bis 30, welche sich von den in Tabelle 2 dargestellten Herstellungsbeispielen 1 bis 15 lediglich dahingehend unterscheiden, dass in der Schichtenfolge jeweils vor der Abscheidung der ersten undotierten Diamantschicht gemäß Verfahrensbedingungen A, B oder C eine zusätzliche undotierte Diamantschicht unter Verwendung der Verfahrensbedingungen I abgeschieden wird. Beispielsweise ergibt sich für das Herstellungsbeispiel 16 durch Anwendung der Verfahrensbedingungen I im Rahmen des Herstellungsbeispiels 1 aus der Schichtenfolge AD die Schichtenfolge IAD.

### Herstellungsbeispiele der dritten und vierten Ausführungsform

Herstellungsbeispiele für die Herstellung eines Körpers bzw. eines Werkzeugs mit einem mehrschichtig ausgebildeten Verschleißschutzschichtsystem gemäß der dritten Ausführungsform wurden zunächst entsprechend dem oben beschriebenen allgemeinen Verfahren für die Herstellung eines Körpers bzw. eines Werkzeugs mit einem mehrschichtig ausgebildeten Verschleißschutzschichtsystem gemäß der ersten Ausführungsform durchgeführt und unterscheiden sich von diesen lediglich dahingehend, dass zusätzlich nach der Abscheidung der zweiten elektrisch isolierenden undotierten Diamantschicht auf der ersten elektrisch leitfähigen undotierten Diamantschicht im laufenden Betrieb zusätzlich eine dritte elektrisch leitfähige undotierte Diamantschicht auf der zweiten undotierten Diamantschicht abgeschieden wurde. Hierfür wurden dieselben Verfahrensbedingungen angewendet, welche in den Herstellungsbeispielen 1 bis 30 im Zusammenhang mit der Abscheidung der ersten undotierten Diamantschicht - mit anderen Worten die Verfahrensbedingungen A, B oder C - Anwendung fanden. Anschließend erfolgte im laufenden Betrieb die Abscheidung einer vierten elektrisch isolierenden undotierten Diamantschicht auf der dritten undotierten Diamantschicht. Hierfür wurden dieselben Verfahrensbedingungen angewendet, welche in den Herstellungsbeispielen 1 bis 30 im Zusammenhang mit der Abscheidung der zweiten undotierten Diamantschicht - mit anderen Worten die Verfahrensbedingungen D, E, F, G oder H - Anwendung fanden. Die entsprechenden Verfahrensbedingungen sind, erneut lediglich zur besseren Darstellbarkeit, in Tabelle 3 zusammengefasst:

**Tabelle 3: Verfahrensbedingungen (I, A, B, C, D, E, F, G bzw. H) für Abscheidungen der ersten, zweiten, dritten und vierten undotierten Diamantschicht, sowie der zusätzlichen undotierten Diamantschicht.**

| Herstelllungsbeispiele 31 - 479 | | H₂-Massenstrom [sccm] | CH₄-Massenstrom [sccm] | Beschichtungstemperatur [°C] | Druck [hPa] | Beschichtungsz eit[h] | Schichtdicke [µm] | Korngröße [nm] | Elektrische Leitfähigkeit [S/cm] |
|---|---|---|---|---|---|---|---|---|---|
| Zusätzliche undotierte Diamantschicht | I | 1500 | 22 | 650 | 5 | 4 | 1 | 113,4 | 3,3×10⁻⁸ |
| Erste elektrisch leitfähige undotierte Diamantschicht | A | 1500 | 105 | 700 | 5 | 17 | 1 | 5,3 | 10,13 |
| | B | 2000 | 92 | 700 | 9 | 19 | 1 | 5,9 | 10,01 |
| | C | 1500 | 100 | 750 | 3 | 15 | 1 | 4,8 | 11,78 |
| Zweite elektrisch isolierende undotierte Diamantschicht | D | 1500 | 44 | 650 | 5 | 40 | 8 | 20,7 | 5,4×10⁻⁶ |
| | E | 1500 | 45 | 700 | 3 | 32 | 8 | 15,1 | 9,8×10⁻⁶ |
| | F | 2000 | 42 | 650 | 9 | 35 | 8 | 32,4 | 2,1×10⁻⁶ |
| | G | 1500 | 20 | 650 | 5 | 10 | 3 | 138,7 | 9,2×10⁻⁹ |
| | H | 1500 | 25 | 700 | 9 | 15 | 5 | 118,6 | 1,4×10⁻⁸ |
| Dritte elektrisch leitfähige undotierte Diamantschicht | A | 1500 | 105 | 700 | 5 | 17 | 1 | 5,3 | 10,13 |
| | B | 2000 | 92 | 700 | 9 | 19 | 1 | 5,9 | 10,01 |
| | C | 1500 | 100 | 750 | 3 | 15 | 1 | 4,8 | 11,78 |
| Vierte elektrisch isolierende undotierte Diamantschicht | D | 1500 | 44 | 650 | 5 | 40 | 8 | 20,7 | 5,4×10⁻⁶ |
| | E | 1500 | 45 | 700 | 3 | 32 | 8 | 15,1 | 9,8×10⁻⁶ |
| | F | 2000 | 42 | 650 | 9 | 35 | 8 | 32,4 | 2,1×10⁻⁶ |
| | G | 1500 | 20 | 650 | 5 | 10 | 3 | 138,7 | 9,2×10⁻⁹ |
| | H | 1500 | 25 | 700 | 9 | 15 | 5 | 118,6 | 1,4×10⁻⁸ |

Die Anwendung der in Tabelle 3 dargestellten Verfahrensbedingungen resultiert in den in folgender Tabelle 4 dargestellten Herstellungsbeispielen 31 bis 255, gemäß welchen ein Körper bzw. ein Werkzeug mit einem mehrschichtig ausgebildeten Verschleißschutzschichtsystem gemäß der dritten Ausführungsform mit den entsprechenden Schichtenfolgen hergestellt werden kann, wobei die sich durch Anwendung der Verfahrensbedingungen ergebenden Schichten jeweils mit den den Verfahrensbedingungen entsprechenden Buchstaben bezeichnet sind.

**Tabelle 4: Herstellungsbeispiele 31 bis 255 und Schichtenfolgen.**

| Herstellungs beispiel | Schichtenfolge | Herstellungs beispiel | Schichtenfolge | Herstellungs beispiel | Schichtenfolge | Herstellungs beispiel | Schichtenfolge |
|---|---|---|---|---|---|---|---|
| 31 | ADAD | 91 | AHAD | 151 | BGAD | 211 | CFAD |
| 32 | ADAE | 92 | AHAE | 152 | BGAE | 212 | CFAE |
| 33 | ADAF | 93 | AHAF | 153 | BGAF | 213 | CFAF |
| 34 | ADAG | 94 | AHAG | 154 | BGAG | 214 | CFAG |
| 35 | ADAH | 95 | AHAH | 155 | BGAH | 215 | CFAH |
| 36 | ADBD | 96 | AHBD | 156 | BGBD | 216 | CFBD |
| 37 | ADBE | 97 | AHBE | 157 | BGBE | 217 | CFBE |
| 38 | ADBF | 98 | AHBF | 158 | BGBF | 218 | CFBF |
| 39 | ADBG | 99 | AHBG | 159 | BGBG | 219 | CFBG |
| 40 | ADBH | 100 | AHBH | 160 | BGBH | 220 | CFBH |
| 41 | ADCD | 101 | AHCD | 161 | BGCD | 221 | CFCD |
| 42 | ADCE | 102 | AHCE | 162 | BGCE | 222 | CFCE |
| 43 | ADCF | 103 | AHCF | 163 | BGCF | 223 | CFCF |
| 44 | ADCG | 104 | AHCG | 164 | BGCG | 224 | CFCG |
| 45 | ADCH | 105 | AHCH | 165 | BGCH | 225 | CFCH |
| 46 | AEAD | 106 | BDAD | 166 | BHAD | 226 | CGAD |
| 47 | AEAE | 107 | BDAE | 167 | BHAE | 227 | CGAE |
| 48 | AEAF | 108 | BDAF | 168 | BHAF | 228 | CGAF |
| 49 | AEAG | 109 | BDAG | 169 | BHAG | 229 | CGAG |
| 50 | AEAH | 110 | BDAH | 170 | BHAH | 230 | CGAH |
| 51 | AEBD | 111 | BDBD | 171 | BHBD | 231 | CGBD |
| 52 | AEBE | 112 | BDBE | 172 | BHBE | 232 | CGBE |
| 53 | AEBF | 113 | BDBF | 173 | BHBF | 233 | CGBF |
| 54 | AEBG | 114 | BDBG | 174 | BHBG | 234 | CGBG |
| 55 | AEBH | 115 | BDBH | 175 | BHBH | 235 | CGBH |
| 56 | AECD | 116 | BDCD | 176 | BHCD | 236 | CGCD |
| 57 | AECE | 117 | BDCE | 177 | BHCE | 237 | CGCE |
| 58 | AECF | 118 | BDCF | 178 | BHCF | 238 | CGCF |
| 59 | AECG | 119 | BDCG | 179 | BHCG | 239 | CGCG |
| 60 | AECH | 120 | BDCH | 180 | BHCH | 240 | CGCH |
| 61 | AFAD | 121 | BEAD | 181 | CDAD | 241 | CHAD |
| 62 | AFAE | 122 | BEAE | 182 | CDAE | 242 | CHAE |
| 63 | AFAF | 123 | BEAF | 183 | CDAF | 243 | CHAF |
| 64 | AFAG | 124 | BEAG | 184 | CDAG | 244 | CHAG |
| 65 | AFAH | 125 | BEAH | 185 | CDAH | 245 | CHAH |
| 66 | AFBD | 126 | BEBD | 186 | CDBD | 246 | CHBD |
| 67 | AFBE | 127 | BEBE | 187 | CDBE | 247 | CHBE |
| 68 | AFBF | 128 | BEBF | 188 | CDBF | 248 | CHBF |
| 69 | AFBG | 129 | BEBG | 189 | CDBG | 249 | CHBG |
| 70 | AFBH | 130 | BEBH | 190 | CDBH | 250 | CHBH |
| 71 | AFCD | 131 | BECD | 191 | CDCD | 251 | CHCD |
| 72 | AFCE | 132 | BECE | 192 | CDCE | 252 | CHCE |
| 73 | AFCF | 133 | BECF | 193 | CDCF | 253 | CHCF |
| 74 | AFCG | 134 | BECG | 194 | CDCG | 254 | CHCG |
| 75 | AFCH | 135 | BECH | 195 | CDCH | 255 | CHCH |
| 76 | AGAD | 136 | BFAD | 196 | CEAD | | |
| 77 | AGAE | 137 | BFAE | 197 | CEAE | | |
| 78 | AGAF | 138 | BFAF | 198 | CEAF | | |
| 79 | AGAG | 139 | BFAG | 199 | CEAG | | |
| 80 | AGAH | 140 | BFAH | 200 | CEAH | | |
| 81 | AGBD | 141 | BFBD | 201 | CEBD | | |
| 82 | AGBE | 142 | BFBE | 202 | CEBE | | |
| 83 | AGBF | 143 | BFBF | 203 | CEBF | | |
| 84 | AGBG | 144 | BFBG | 204 | CEBG | | |
| 85 | AGBH | 145 | BFBH | 205 | CEBH | | |
| 86 | AGCD | 146 | BFCD | 206 | CECD | | |
| 87 | AGCE | 147 | BFCE | 207 | CECE | | |
| 88 | AGCF | 148 | BFCF | 208 | CECF | | |
| 89 | AGCG | 149 | BFCG | 209 | CECG | | |
| 90 | AGCH | 150 | BFCH | 210 | CECH | | |

Wie oben erwähnt kann bei Bedarf durch Anwendung der Verfahrensbedingungen I aus Tabelle 3 eine zusätzliche undotierte Diamantschicht abgeschieden werden, um einen beschichteten Körper bzw. ein Werkzeug gemäß der vierten Ausführungsform herzustellen. Da diese Verfahrensbedingungen I mit den anderen Verfahrensbedingungen A bis C der ersten bzw. dritten, und D bis H der zweiten bzw. vierten undotierten Diamantschicht kombiniert werden können, ergeben sich zusätzlich zu den in Tabelle 4 dargestellten Herstellungsbeispielen 31 bis 255 weitere Herstellungsbeispiele 256 bis 479, welche sich von den in Tabelle 4 dargestellten Herstellungsbeispielen 31 bis 255 lediglich dahingehend unterscheiden, dass in der Schichtenfolge jeweils vor der Abscheidung der ersten undotierten Diamantschicht gemäß Verfahrensbedingungen A, B oder C eine zusätzliche undotierte Diamantschicht unter Verwendung der Verfahrensbedingungen I abgeschieden wird. Beispielsweise ergibt sich für das Herstellungsbeispiel 256 durch Anwendung der Verfahrensbedingungen I im Rahmen des Herstellungsbeispiels 31 aus der Schichtenfolge ADAD die Schichtenfolge IADAD.

### Messprinzipien

Die Messung der Schichtdicken erfolgte mittels Reflektometrischer Interferenzspektroskopie (RlfS). Hierbei konnte bestätigt werden, dass die elektrisch leitfähigen Diamantschichten eine Schichtdicke von 1 bis 2 µm aufwiesen, wohingegen die zum Verschleiß dienenden elektrisch isolierenden undotierten Diamantschichten eine Schichtdicke von 3 bis 8 µm aufwiesen. Die Gesamtschichtdicke des mehrschichtig ausgebildeten Verschleißschutzschichtsystems betrug für Körper bzw. Werkzeuge gemäß der ersten bzw. zweiten Ausführungsform etwa 4 bis 10 µm. Die Gesamtschichtdicke des mehrschichtig ausgebildeten Verschleißschutzschichtsystems betrug für Körper bzw. Werkzeuge gemäß der dritten bzw. vierten Ausführungsform etwa 8 bis 20 µm.

Die elektrischen Eigenschaften wurden nach der Vierpunktmethode gemäß L. B. Valdes et al. 1954 bestimmt. Hierdurch erfolgte eine Klassifizierung der Diamantschichten nach ihren spezifischen elektrischen Leitfähigkeiten jeweils als elektrisch leitfähig und elektrisch isolierend. Die Messungen bestätigten, dass die elektrische Leitfähigkeit der elektrisch leitfähigen Diamantschichten bei 10,13 S/cm oder höher lag. Währenddessen lag die elektrische Leitfähigkeit der elektrisch isolierenden Diamantschichten zwischen 9,8×10⁻⁶ S/cm und 9,2×10⁻⁹ S/cm. Somit konnte bestätigt werden, dass die elektrische Leitfähigkeit von Diamant verändert werden kann ohne auf eine Dotierung angewiesen zu sein.

Die Ermittlung der Korngröße der Diamantkörner in den entsprechenden Schichten erfolgte durch Gitterstrukturanalyse via Messung von XRD-Spektren an einem Siemens D5005 X-Ray Diffractometer. Die Primärstrahlung entsprach einer monochromatischen Cu-K_{α} Strahlung mit einer Wellenlänge von 154,2 pm (1,542 Å). Die Auswertung der durchschnittlichen Diamantkorngröße erfolgte anhand der Halbwertsbreite (FWHM) des Diamant (111)-Peaks um 2θ = 43,9°. Für das Peakfitting und die Auswertungen wurde die Software Fityk (Version 1.3.1) genutzt. Die entsprechend erhaltenen Werte sind in Tabelle 1 und 3 angegeben. Es konnte somit bestätigt werden, dass bei Anwendung der Verfahrensbedingungen A, B oder C elektrisch leitfähige undotierte Diamantschichten mit nanokristalliner Strukturierung, und hierbei insbesondere mit Diamantkorngrößen im niedrig-nanokristallinen Bereich, erhalten werden. Zudem konnte bestätigt werden, dass bei Anwendung der Verfahrensbedingungen D, E, F, G, H und I elektrisch isolierende undotierte Diamantschichten mit Diamantkorngrößen im höher-nanokristallinen bzw. niedrig-mikrokristallinen Bereich erhalten werden. Zudem konnte gezeigt werden, dass der CH₄-Massenstrom den Hauptbeitrag zur Gestaltung der Diamantkorngröße leistet. So erfolgt bei der Anwendung eines CH₄-Massenstroms von etwa 90 bis 105 sccm die Ausbildung von nanokristallinen Diamantkörnern im Bereich von etwa 5 nm bis 6 nm, bei der Anwendung eines CH₄-Massenstroms von etwa 40 bis 45 sccm die Ausbildung von nanokristallinen Diamantkörnern im Bereich von etwa 15 nm bis 33 nm, und bei der Anwendung eines CH₄-Massenstroms von etwa 20 bis 25 sccm die Ausbildung von Diamantkörnern im Bereich von größer 100 nm.

Zusätzlich können durch Wahl der Verfahrensbedingungen für die Abscheidung der äußersten Schicht im mehrschichtig ausgebildeten Verschleißschutzschichtsystem gemäß erster, zweiter, dritter oder vierter Ausführungsform, i.e. der zweiten bzw. vierten undotierten Diamantschicht, die Eigenschaften des Körpers bzw. Werkzeugs gezielt beeinflusst werden: so wirkt sich die Wahl eines niedrigeren CH₄-Massenstroms von ca. 20 sccm dahingehend aus, dass die Härte sowie der E-Modul der Schicht verbessert werden, jedoch die Oberflächenrauheit, und somit der Reibungskoeffizient, ebenfalls erhöht werden. Wird beispielweise die Anwendung bei Körpern oder Werkzeugen, welche starken Reibungskräften ausgesetzt sind, angestrebt werden, so wäre ein höher CH₄-Massenstroms von ca. 45 sccm anzuwenden, da sich hierdurch eine geringere Oberflächenrauheit und im Vergleich niedrigerer Reibungskoeffizient ergibt.

### Bezugszeichenliste

- 100, 300, 500, 700: Beschichteter Körper
- 200, 400, 600, 800: Werkzeug
- 101, 201, 301, 401,: Mehrschichtig ausgebildetes Verschleißschutzschichtsystem
- 501, 601, 701, 801 102, 302, 502, 702: Körper
- 202, 402, 602, 802: Werkzeugkörper
- 103, 203, 303, 403,: Erste elektrisch leitfähige undotierte Diamantschicht
- 503, 603, 703, 803 104, 204, 304, 404,: Zweite elektrisch isolierende undotierte Diamantschicht
- 504, 604, 704, 804 505, 605, 705, 805: Dritte elektrisch leitfähige undotierte Diamantschicht
- 506, 606, 706, 806: Vierte elektrisch isolierende undotierte Diamantschicht
- 307, 407, 707, 807: Zusätzliche undotierte Diamantschicht

## Patentansprüche

1. Körper (102, 202, 302, 402, 502, 602, 702, 802) aus Metall, einem metallkeramischen Verbund oder Keramik mit einem auf einer verschleißbeanspruchten Funktionsfläche des Körpers mehrschichtig ausgebildeten Verschleißschutzschichtsystem (101, 201, 301, 401, 501, 601, 701, 801), **dadurch gekennzeichnet, dass**
das Verschleißschutzschichtsystem (101, 201, 301, 401, 501, 601, 701, 801) wenigstens eine erste elektrisch leitfähige undotierte Diamantschicht (103, 203, 303, 403, 503, 603, 703, 803) und eine auf der ersten undotierten Diamantschicht (103, 203, 303, 403, 503, 603, 703, 803) angeordnete zweite elektrisch isolierende undotierte Diamantschicht (104, 204, 304, 404, 504, 604, 704, 804) umfasst, wobei
die erste elektrisch leitfähige undotierte Diamantschicht (103, 203, 303, 403, 503, 603, 703, 803) n-leitfähig ist.

2. Körper (102, 202, 302, 402, 502, 602, 702, 802) nach Anspruch 1, wobei eine Korngröße der Diamantkörner in der ersten undotierten Diamantschicht (103, 203, 303, 403, 503, 603, 703, 803) in einem Bereich von 4 nm bis 10 nm, vorzugsweise in einem Bereich von 5 nm bis 6 nm, und besonders bevorzugt in einem Bereich gegen 5 nm, liegt.

3. Körper (102, 202, 302, 402, 502, 602, 702, 802) nach Anspruch 1 oder 2, wobei die Schichtdicke der ersten undotierten Diamantschicht (103, 203, 303, 403, 503, 603, 703, 803) im Bereich von 4 bis 20 µm, vorzugsweise 6 bis 8 µm, liegt, und die Schichtdicke der zweiten undotierten Diamantschicht (104, 204, 304, 404, 504, 604, 704, 804) im Bereich von 4 bis 20 µm, vorzugsweise 6 bis 8 µm, liegt.

4. Körper (102, 202, 302, 402, 502, 602, 702, 802) nach einem der vorhergehenden Ansprüche, wobei die erste und die zweite Diamantschicht (103, 203, 303, 403, 503, 603, 703, 803; 104, 204, 304, 404, 504, 604, 704, 804) mittels chemischer Dampfabscheidung (CVD), vorzugsweise Heißdrahtverfahren, aufgetragen sind.

5. Körper (102, 202, 302, 402, 502, 602, 702, 802) nach einem der vorherigen Ansprüche, wobei der Körper (102, 202, 302, 402, 502, 602, 702, 802) Hartstoffpartikel auf Carbid- und/oder Nitrid- und /oder Borid- und/oder Oxid- und/oder Silizid- und/oder Phosphid-Basis enthält, welche in eine cobalt- und/oder nickelhaltige Bindematrix eingebettet sind.

6. Körper (102, 202, 302, 402, 502, 602, 702, 802) nach einem der vorherigen Ansprüche, wobei die Hartstoffpartikel ausgewählt sind aus der Gruppe, bestehend aus Verbindungen auf Carbid- und/oder Nitrid- und /oder Borid- und/oder Oxid- und/oder Silizid- und/oder Phosphid-Basis der Metalle der IV., V. und VI. Nebengruppe des Periodensystems der Elemente, weiterhin des Bors, des Aluminiums und des Siliziums entweder in reiner Form oder in Mischphasen, insbesondere Titancarbid, Titannitrid, Titancarbonitrid, Wolframcarbid, Vanadiumcarbid, Niobcarbid, Tantalcarbid, Chromcarbid, Molybdäncarbid, (W,Co)₆C, Titandiborid, Zirkondiborid, Hafniumdiborid, Siliziumnitrid, Titanaluminiumnitrid, Aluminiumoxid, Zirkonoxid, Chromoxid oder Spinelle.

7. Körper (302, 402, 702, 802) nach einem der vorherigen Ansprüche, wobei das mehrschichtig ausgebildete Verschleißschutzschichtsystem (301, 401, 701, 801) eine zusätzliche, unter der ersten undotierten Diamantschicht (303, 403, 703, 803) angeordnete, undotierte Diamantschicht (307, 407, 707, 807) aufweist, welche vorzugsweise in ihrer Zusammensetzung der zweiten undotierten Diamantschicht (304, 404, 704, 804) entspricht.

8. Körper (502, 602, 702, 802) nach einem der vorherigen Ansprüche, wobei das mehrschichtig ausgebildete Verschleißschutzschichtsystem (501, 601, 701, 801) auf der zweiten undotierten Diamantschicht (504, 604, 704, 804) eine dritte undotierte Diamantschicht (505, 605, 705, 805) und eine auf der dritten undotierten Diamantschicht (505, 605, 705, 805) angeordnete vierte undotierte Diamantschicht (506, 606, 706, 806) aufweist, wobei
die dritte undotierte Diamantschicht (505, 605, 705, 805) vorzugsweise die gleiche Zusammensetzung wie die erste undotierte Diamantschicht (503, 603, 703, 803) aufweist, und die vierte undotierte Diamantschicht (506, 606, 706, 806) vorzugsweise die gleiche Zusammensetzung wie die zweite Diamantschicht (504, 604, 704, 804) aufweist.

9. Körper (202, 402, 602, 802) nach einem der vorherigen Ansprüche, wobei es sich bei dem Körper um ein spanabhebendes oder spanlos arbeitendes Werkzeug (200, 400, 600, 800) handelt.

10. Körper (202, 402, 602, 802) nach Anspruch 9, wobei das spanabhebende oder spanlos arbeitende Werkzeug als rotierendes oder als stehendes Werkzeug, insbesondere als Bohr-, Fräs-, Senk-, Dreh-, Gewinde-, Konturier- oder Reibwerkzeug ausgebildet ist.

11. Verfahren zur Herstellung eines Körpers gemäß einem der Ansprüche 1 - 8, wobei das Verfahren das Aufbringen eines mehrschichtig ausgebildeten Verschleißschutzschichtsystems auf eine verschleißbeanspruchte Funktionsfläche eines Körpers aus Metall, einem metallkeramischen Verbund oder Keramik mittels chemischer Dampfabscheidung (CVD) aus einer Methan/Wasserstoff-Atmosphäre in einer CVD-Kammer umfasst.

12. Verfahren zur Herstellung eines Körpers nach Anspruch 13, wobei Wasserstoff dem Methan im molaren Überschuss zugemischt wird, und eine Beschichtungstemperatur von 650°C bis 1100°C, vorzugsweise 650°C bis 750°C, und ein Beschichtungsdruck von 1 mbar bis 10 mbar bzw. 1 hPa bis 10 hPa eingestellt wird.

13. Verfahren nach Anspruch 13 oder 14, wobei als CVD-Verfahren ein Heißdrahtverfahren zum Einsatz kommt, bei welchem vorzugsweise ein W-Draht als Heizdraht verwendet wird.
